# EUROPEAN PATENT SPECIFICATION

(11) **EP 2 665 089 B1**
(45) Date of publication and mention of the grant of the patent: **29.06.2016**
(21) Application number: 12734324.2
(22) Date of filing: 11.01.2012
(51) Int. Cl.: H01L 21/22, H01L 21/225, H01L 21/228, H01L 31/18

(54) **COMPOSITION FOR FORMING p-TYPE DIFFUSION LAYER, METHOD OF PRODUCING SILICON SUBSTRATE HAVING p-TYPE DIFFUSION LAYER, METHOD FOR PRODUCING PHOTOVOLTAIC CELL , AND PHOTOVOLTAIC CELL**
ZUSAMMENSETZUNG ZUR BILDUNG EINER P-LEITENDEN DIFFUSIONSSCHICHT, VERFAHREN ZUR HERSTELLUNG EINES SILIZIUMSUBSTRATS MIT EINER P-LEITENDEN DIFFUSIONSSCHICHT, VERFAHREN ZUR HERSTELLUNG EINER PHOTOVOLTAISCHEN ZELLE UND PHOTOVOLTAISCHE ZELLE
COMPOSITION DE FORMATION DE COUCHE DE DIFFUSION DE TYPE p, PROCÉDÉ DE PRODUCTION D'UN SUBSTRAT DE SILICIUM AYANT UNE COUCHE DE DIFFUSION DE TYPE p, PROCÉDÉ DE PRODUCTION D'UN ÉLÉMENT DE PILE PHOTOVOLTAÏQUE, ET PILE PHOTOVOLTAÏQUE

(30) Priority: 13.01.2011 JP 2011005333; 15.07.2011 JP 2011157227; 15.07.2011 JP 2011157228; 15.07.2011 JP 2011157229; 15.07.2011 JP 2011157230
(43) Date of publication of application: 20.11.2013
(73) Proprietor: Hitachi Chemical Company, Ltd., Chiyoda-ku Tokyo 100-6606 (JP)
(72) Inventor: ORITA, Akihiro, Tsukuba-shi Ibaraki 300-4247 (JP); YOSHIDA, Masato, Tsukuba-shi Ibaraki 300-4247 (JP); NOJIRI, Takeshi, Tsukuba-shi Ibaraki 300-4247 (JP); MACHII, Yoichi, Tsukuba-shi Ibaraki 300-4247 (JP); IWAMURO, Mitsunori, Tsukuba-shi Ibaraki 300-4247 (JP); KIZAWA, Keiko, Tsukuba-shi Ibaraki 300-4247 (JP); ADACHI, Shuichiro, Tsukuba-shi Ibaraki 300-4247 (JP); SATO, Tetsuya, Tsukuba-shi Ibaraki 300-4247 (JP)
(74) Representative: Hoffmann Eitle
(86) International application number: PCT/JP2012/050391
(87) International publication number: WO 2012/096311

(56) References cited:
- WO-A1-2009/116569
- WO-A1-2009/116569
- JP-A- S5 618 416
- JP-A- 2002 093 734
- JP-A- 2003 069 056
- JP-A- 2003 069 056
- JP-A- 2010 157 654
- JP-A- 2010 157 654
- JP-A- 2013 026 523
- US-A1- 2012 152 345
- US-A1- 2013 153 019

## Description

### BACKGROUND OF THE INVENTION

### [Field of the Invention]

The present invention relates to a composition for forming a p-type diffusion layer, a method of producing a silicon substrate having a p-type diffusion layer, a method of producing a photovoltaic cell, and a photovoltaic cell.

### [Background of the Invention]

A conventional method for producing a silicon photovoltaic cell element will be explained.

First, a p-type silicon substrate, on which a texture is formed in order to improve efficiency by promoting a light trapping effect, is prepared. Subsequently, an n-type diffusion layer is uniformly formed by performing a treatment in an atmosphere of a mixed gas of phosphorus oxychloride (POCl₃), nitrogen and oxygen, at from 800 °C to 900 °C for several ten minutes. According to this conventional method, since diffusion of phosphorus is conducted by using a mixed gas, an n-type diffusion layer is formed not only on a front surface but also on side and back surfaces. Therefore, side etching is carried out in order to remove the n-type diffusion layers formed on the side surfaces. The n-type diffusion layer formed on the back surface needs to be converted to a p⁺-type diffusion layer. Therefore, an aluminum paste is printed on the back surface and sintered, and an ohmic contact is obtained at the time of converting the n-type diffusion layer to a p⁺-type diffusion layer.

However, an aluminum layer formed from an aluminum paste is low in conductivity. Therefore, in order to lower the sheet resistance, the aluminum layer formed on the entire area of the back surface needs to have a thickness of approximately from 10 µm to 20 µm after sintering. Further, the coefficients of thermal expansion of silicon and aluminum are significantly different. Therefore, a large internal stress is created in a silicon substrate during sintering and cooling, and the internal stress may cause damage to crystal grain boundaries, an increase in crystal defects or warpage.

In order to solve the problems as described above, there is a method of reducing the thickness of back-surface electrode layers by reducing the amount of an aluminum paste to be applied. However, if the amount of the aluminum paste is reduced, the amount of aluminum that diffuses into the inside of a p-type silicon semiconductor from its surface may be insufficient. As a result, a desired BSF (Back Surface Field) effect, i.e., an effect of improving collection efficiency of photogenerated carriers due to the presence of the p⁺-type diffusion layer, may not be attained and the performances of the photovoltaic cell may become low.

In connection to the above, a technique of using a boron compound such as boron or boron oxide as a dopant has been proposed (see, for example, Patent Document 1).

Further, a technique of using a sintered body of boron nitride as a boron dopant has been proposed (see, for example, Patent Document 2).

Further, a technique of using a powder of boron nitride as a boron dopant has been proposed (see, for example, Non-patent Document 1).

### [Prior Art Documents]

### [Patent Documents]

[Patent Document 1] Japanese Patent Application Laid-Open (JP-A) No. 2002-539615
[Patent Document 3] JP 2003 069056 A [Patent Document 2] Japanese Patent No. 4347254

### [Non-Patent Document]

[Non-patent Document 1] Joge et. al. Jpn. J. Appl. Phys. Vol. 42 (2003) pp. 5397-5404

### [Summary of the Invention]

### [Problem to be Solved]

However, as described in Patent Document 1, if boric acid or is used as a dopant for forming a p⁺-type diffusion layer, the ability of diffusion is insufficient and a sufficient BSF effect may not be attained. Further, there are cases in which boric acid or the like may react with a silicon substrate and cause precipitation of a crystalline component, and the crystalline component may become a resistance component. Moreover, a solution for forming a diffusion layer that contains boric acid or B₂O₃ may have a problem in its storage stability.

In the method described in Patent Document 2, it is necessary to allow boron to diffuse at a temperature of 1000°C or higher. Therefore, a silicon substrate may damage and deteriorate the cell efficiency. In addition, in order to selectively diffuse boron, there is a need to mask portions that are to be protected from diffusion with SiO₂ or the like. As a result, the number of steps increases and the process becomes complex.

The present invention has been made in view of the aforementioned, and provides a composition for forming a p-type diffusion layer that enables formation of a p-type diffusion layer having a low resistivity while suppressing warpage of a silicon substrate during a thermal treatment, and suppressing reaction of a component of the composition for forming a p-type diffusion layer with the substrate at high temperature; a method of producing a silicon substrate having a p-type diffusion layer; a method of producing a photovoltaic cell; and a photovoltaic cell.

Patent Document 3 describes a paste composition for forming a rear face electrode layer on a p-type silicon semiconductor substrate. The paste composition comprises aluminum powder, an organic vehicle, glass frit, and at least one kind selected among boron powder, an inorganic boron compound, and an organic boron compound. A solar battery is provided with the rear face electrode layer formed by applying the paste composition on the p-type silicon semiconductor substrate and then baking it.

### [Solution to Problem]

The solution to the problem includes the following specific embodiments.
<1> A composition for forming a p-type diffusion layer, the composition comprising boron nitride, a dispersion medium and an inorganic binder, wherein the boron nitride has a BET specific surface area of from 3 m²/g to 200 m²/g.
<2> The composition for forming a p-type diffusion layer according to <1>, wherein the inorganic binder is at least one selected from the group consisting of an organic metal compound and a glass frit.
<3> The composition for forming a p-type diffusion layer according to <2>, wherein the organic metal compound is at least one selected from the group consisting of a metal alkoxide, a silane coupling agent and a silicone resin.
<4> The composition for forming a p-type diffusion layer according to <3>, wherein the metal alkoxide is silicon alkoxide.
<5> The composition for forming a p-type diffusion layer according to <2>, wherein the glass frit comprises borosilicate glass.
<6> The composition for forming a p-type diffusion layer according to any one of <1> 1 to <5>, wherein a content of the inorganic binder is from 1% by mass to 40% by mass.
<7> The composition for forming a p-type diffusion layer according to any one of <1> to <6>, wherein the dispersion medium comprises an organic binder.
<8> The composition for forming a p-type diffusion layer according to any one of <1> to <7>, wherein the boron nitride is boron nitride particles having a crystalline form of a hexagonal crystal.
<9> The composition for forming a p-type diffusion layer according to any one of <1> to <8>, wherein the boron nitride has a peak intensity ratio of peaks each corresponding to (100), (101) and (102) in an X-ray diffraction pattern, represented by [(I₁₀₀)+I(₁₀₁)/I(₁₀₂)], of 3.5 or less.
<10> The composition for forming a p-type diffusion layer according to any one of <1> to <9>, wherein the boron nitride is boron nitride particles having a content of oxygen atoms of 15% by mass or less.
<11> The composition for forming a p-type diffusion layer according to <10>, wherein the boron nitride particles are at least one selected from the group consisting of a product that has been subjected to mechanical surface modification and a product that has been subjected to a thermal treatment.
<12> A method of producing a silicon substrate having a p-type diffusion layer, the method comprising a process of applying, to a silicon substrate, the composition for forming a p-type diffusion layer according to any one of <1> to <11> and, after the process of applying, a process of performing a thermal diffusion treatment by heating the silicon substrate.
<13> A method of producing a photovoltaic cell element, the method comprising a process of applying, to a silicon substrate, the composition for forming a p-type diffusion layer according to any one of <1> to <11> and, after the process of applying, a process of forming a p-type diffusion layer by performing a thermal diffusion treatment by heating the silicon substrate, and a process of forming an electrode on the p-type diffusion layer.
<14> A method of producing a silicon substrate having a p-type diffusion layer that has a selective emitter structure, the method comprising a process of applying, to a silicon substrate, the composition for forming a p-type diffusion layer according to any one of <1> to <11> by a method that is at least one selected from the following (1) to (3) and, after the process of applying, a process of performing a thermal diffusion treatment by heating the silicon substrate:
   (1) using at least two compositions for forming a p-type diffusion layer having different concentrations of boron nitride as the composition for forming a p-type diffusion layer, and applying, to the selected region, a composition for forming a p-type diffusion layer having a higher concentration of boron nitride;
   (2) applying, to the selected region, a composition for forming a p-type diffusion layer more than once; and
   (3) applying, to the selected region, a composition for forming a p-type diffusion layer that includes highly diffusive boron nitride.
<15> The method of producing a silicon substrate having a p-type diffusion layer according to <14>, wherein the application of the composition for forming a p-type diffusion layer to the selected region is an inkjet method, an offset printing method or a screen printing method.
<16> The method of producing a silicon substrate having a p-type diffusion layer according to <14> or <15>, wherein the process of application comprises:
   a first application process in which the composition for forming a p-type diffusion layer is partially applied to the selected region and dried; and
   a second application process in which the composition for forming a p-type diffusion layer is applied to an entire region of the surface to which the application is carried out in the first application process, and dried.
<17> The method of producing a silicon substrate having a p-type diffusion layer according to <14> or <15>. wherein the process of application comprises:
   a first application process in which the composition for forming a p-type diffusion layer is applied to an entire region including the selected region and dried; and
   a second application process in which the composition for forming a p-type diffusion layer is partially applied to the selected region, and dried.
<18> A method of producing a photovoltaic cell element, the method comprising a process of forming an electrode on the selected region of the silicon substrate having a p-type diffusion layer that has been produced by the method according to any one of <14> to <17>.
<19> A photovoltaic cell comprising the photovoltaic cell element that is produced by the method according to <13> or <18>, and a tab line that is positioned on the electrode of the photovoltaic cell element.

### [Effect of the Invention]

According to the present invention, it is possible to provide a composition for forming a p-type diffusion layer that enables formation of a p-type diffusion layer having a low resistivity while suppressing warpage of a silicon substrate during a thermal treatment, and suppressing reaction of a component of the composition for forming a p-type diffusion layer with the substrate at high temperature; a method of producing a silicon substrate having a p-type diffusion layer; a method of producing a photovoltaic cell; and a photovoltaic cell.

### [Brief Description of the Drawings]

Fig. 1 is a schematic sectional view showing an example of the method of producing a p-type diffusion layer according to the invention.
Fig. 2 is a schematic sectional view showing an example of the method of producing a photovoltaic cell element according to the invention.
Fig. 3 is a schematic sectional view showing an example of the method of producing a photovoltaic cell element according to the invention.
Fig. 4 is a schematic sectional view showing an example of the method of producing a photovoltaic cell element according to the invention.

### [Embodiments for Implementing the Invention]

In the specification, the term "step" encompasses not only an independent step, but also a step that attain an expected effect even if it is not distinguishable from other steps. The numerical range described as "from ... to ..." includes the lower endpoint as the minimum value and the upper endpoint as the maximum value. In a case in which plural materials constitute a component in a composition, the amount of the component refers to the total amount of the materials, unless otherwise defined

### <Composition for Forming P-Type Diffusion Layer>

The composition for forming a p-type diffusion layer of the present invention includes boron nitride, a dispersion medium as described below, and at least one inorganic binder. If necessary, the composition includes other additives in consideration of application suitability or the like.

In the specification, the composition for forming a p-type diffusion layer refers to a material that includes a boron compound, and is capable of forming a p-type diffusion layer by applying the material onto a silicon substrate and allowing boron atoms included in the boron compound to thermally diffuse into the silicon substrate.

The composition for forming a p-type diffusion layer exhibits, by using boron nitride as the boron compound, suppressed moisture absorption and suppressed reactivity with the dispersion medium, and improved storage stability. Further, since the reactivity with a silicon substrate is suppressed and formation of a crystalline resistance component is suppressed, the resistance of the p-type diffusion layer can be lowered. In a case in which boric acid or B₂O₃ is used as the boron compound, the compound may react with the silicon substrate and form a crystalline resistance component. Further, in a case in which boric acid or B₂O₃ is used, storage stability of the composition for forming a p-type diffusion layer may deteriorate due to reaction with the dispersion medium, moisture absorption, or the like.

In addition, in the composition for forming a p-type diffusion layer, the inorganic binder binds boron nitride during a thermal diffusion process, thereby suppressing scattering of boron nitride. Further, in a case in which a composition for forming a p-type diffusion layer that includes an inorganic binder is used, scattering of boron nitride during a thermal diffusion process is made difficult, and contamination of an apparatus may be prevented.

In addition, in a case in which the composition for forming a p-type diffusion layer is used, a process of forming a p-type diffusion layer can be separated from a process of forming an ohmic contact on the p-type diffusion layer. Therefore, the material for an electrode for forming an ohmic contact can be selected from a wider range of options. For example, a lower resistance can be achieved with a small thickness by using a material that is low in resistance, such as silver, as a material for an electrode. Further, in a case in which the composition for forming a p-type diffusion layer is used, an electrode needs not be formed on an entire region and the structure of the electrode can be selected from a wider range of options. For example, it is possible to apply the composition to a structure in which an electrode is partially formed, such as in a comb shape.

As such, according to the composition for forming a p-type diffusion layer, it is possible to form a p-type diffusion layer while suppressing an internal stress in a silicon substrate or suppressing warpage thereof, by forming an electrode having a small thickness or a comb shape.

Therefore, according to the composition for forming a p-type diffusion layer of the present invention, it is possible to suppress an internal stress in the substrate and warpage thereof, which tends to occur in a common method of printing an aluminum paste and sintering the same to convert an n-type diffusion layer to a p⁺-type diffusion layer and, at the same time, forming an ohmic contact.

In addition, since the composition for forming a p-type diffusion layer of the present invention eases restrictions on the structure of the electrode, a p⁺-type diffusion layer having a desired configuration can be formed. The composition for forming a p-type diffusion layer of the present invention can be used to form a p⁺ type-diffusion layer of, for example, a bifacial photovoltaic cell in which an aluminum paste cannot be printed on the entire surface thereof.

### (A) Boron Nitride

The boron nitride according to the present invention will be described in detail.

The composition for forming a p-type diffusion layer of the present invention includes boron nitride. The composition may further include a boron compound other than boron nitride, if necessary.

Since boron nitride is chemically stable, it can suppress moisture absorption or reactivity with the dispersion medium, thereby improving storage stability. Further, boron nitride can inhibit formation of a reaction product of a boron compound with silicon that may occur during a thermal diffusion process. In addition, it is possible to attain a favorable diffusibility of boron by suppressing scattering of a dopant compound even during thermal diffusion at high temperature (for example, 800°C or higher), and a low resistance p-type diffusion layer can be formed. In addition, since boron nitride is dispersed in the dispersion medium as described below, a p-type diffusion layer in which boron atoms are dispersed more uniformly can be formed, and it is also possible to form a p-type diffusion layer selectively.

The boron nitride is preferably in the form of particles. Examples of the shape of the boron nitride particles include a near spherical form, a flat form, a blocky form, a platelet form, and a flaky form. In consideration of properties of application to a substrate and uniform diffusivity of the composition for forming a p-type diffusion layer, boron nitride particles preferably have a near spherical, flat or platelet shape. In particular, in a case in which boron nitride particles have a flat shape or a platelet shape, which has a high aspect ratio, the boron nitride particles tend to be oriented upon application of a paste including the same onto a substrate, thereby achieving a low resistivity.

Although the reasons for such effects are not clear, it is thought that, for example, it becomes easy to cover a silicon substrate with boron nitride due to its oriented state, which suppresses diffusion of a boron compound that volatilizes from the boron nitride, and it facilitates the boron compound gas to contact the silicon contact, thereby promoting diffusion of boron.

The particle shape can be determined by observing with a scanning electron microscope.

Preferably, the boron nitride particles have a peak intensity ratio of peaks each corresponding to the (100) plane, the (101) plane and the (102) plane, represented by (I₍₁₀₀₎ + I₍₁₀₁₎ / (I₍₁₀₂₎), of 3.5 or less in its X-ray diffraction spectrum. The lower limit is not limited, but is preferably 0.1 or more, more preferably from 0.1 to 2.0, for example. If the peak intensity is 3.5 or less, the boron nitride particles exhibit a high crystallinity or a favorable orientation, and diffusivity of boron is maintained during thermal diffusion into a silicon substrate. It is thought that a boron-containing gas that volatilizes from the boron nitride particles can be readily trapped due to the high crystallinity and the favorable orientation to the silicon substrate, whereby the concentration of the boron-containing gas near the surface of the silicon substrate is increased. In contrast, if the boron nitride particles are low in orientation, a boron-containing gas that volatilizes from the boron nitride particles may readily diffuse and the gas is less likely to contact the silicon substrate, thereby lowering the diffusivity. In the specification, the "orientation" refers to an index of easiness of orientation of boron nitride when the boron nitride is disposed on a silicon substrate along a certain crystallographic axis of the boron nitride particles.

The peak intensity ratio in the X-ray diffraction spectrum is determined under the following conditions: X-ray source: Cu-Kα, power: 40 kV and 20 mA, entrance slit: 1 °, scattering slit: 1°, receiving slit: 0.3 mm, and scanning speed: 2° min⁻¹.

The boron nitride particles preferably have an average primary particle diameter of from 10 nm to 15 µm, more preferably from 10 nm to 12 µm, still more preferably from 10 nm to 5 µm, and still more preferably from 50 nm to 5 µm. If the particles have an average primary particle diameter of 15 µm or less, the particles exhibit more favorable diffusivity and diffusion uniformity.

In the present invention, the "primary particle" refers to the smallest particle that can exist independently and the "average primary particle diameter" refers to the long dimension of the primary particle as determined by scanning electron microscopy. The "long dimension of primary particle" refers to the maximum diameter of a primary particle having a spherical shape, or the maximum diameter or maximum diagonal length of a projection image of a particle having a hexagonal platelet shape or a discoidal shape viewed in a thickness direction. In particular, the "average primary particle diameter" is determined as a number average value of the measured values of the long dimension of 300 particles according to the above method.

The boron nitride particles preferably have a volume average secondary particle diameter (50%D) of from 10 nm to 15 µm, more preferably from 50 nm to 12 µm, and still more preferably from 50 nm to 10 µm, in view of an ability of forming a p-type diffusion layer and dispersion stability. If the particles have a volume average secondary particle diameter of 15 µm or less, the particles can be uniformly dispersed at the surface of a silicon substrate, and the boron can be diffused into a silicon substrate more uniformly. If the particles have a volume average secondary particle diameter of 10 nm or more, the particles can be dispersed in the dispersion medium more easily. In the specification, 50%D refers to a median size that can be measured with a laser scattering diffraction particle diameter distribution analyzer.

The method for adjusting the volume average secondary particle diameter (50%D) of the boron nitride particles to be within the above range is not limited, but a pulverization treatment as described below is preferred. By performing pulverization, it is also possible to reduce the average primary particle diameter. Details of the pulverization are described below.

Although the boron nitride particles may have any of a hexagonal crystal form, a cubic crystal form, or a rhombohedral crystal form, the particles preferably have a hexagonal crystal form in view of readily regulating the size of the particles and the orientation thereof.

In a case in which hexagonal boron nitride particles are used, it is possible to further lower the resistance of a p-type diffusion layer to be formed. It is thought that the hexagonal boron nitride particles are likely to be oriented such that an a-axis (hexagonal net plane) direction is along the surface of a silicon substrate due to its crystal form, and a boron-containing gas that volatilizes from the boron nitride particles is readily trapped, whereby the concentration of the boron-containing gas near the surface of the silicon substrate is increased.

The crystal form of the boron nitride particles can be characterized by an x-ray diffraction pattern. Specifically, in a case in which the boron nitride particles have a hexagonal crystal form, it is characterized by the existence of peaks at 26 = 27°, 42°, 50°, and 55° in the x-ray diffraction pattern. The x-ray diffraction pattern can be obtained by, for example, measuring a powder X-ray diffraction spectrum with an X-ray diffractometer (for example, LAD-2X from Rigaku Corporation).

The boron nitride particles have a BET specific surface area of from 3 m²/g to 200 m²/g. If the particles have a BET specific surface area of 3 m²/g or more, a sufficient diffusivity can be attained. If the particles have a BET specific surface area of 200 m²/g or less, the particles exhibit a favorable dispersibility in the dispersion medium. Preferably, the boron nitride particles have a BET specific surface area of from 10 m²/g to 50 m²/g. If the particles have a high BET specific surface area, the amount of a boron-containing gas that volatilizes from the boron nitride particles is increased, whereby diffusivity is improved.

The BET specific surface area can be determined from nitrogen adsorption isotherms measured at -196°C.

The aspect ratio of the boron nitride particles is not particularly limited, but a higher aspect ratio is preferred. Specifically, the aspect ratio is preferably from 2 to 10. If boron nitride particles having a high aspect ratio are applied onto a silicon substrate and subjected to a thermal treatment, diffusivity of the particles tends to be improved. It is thought that, for example, the boron nitride particles having a high aspect ratio can trap a boron compound that volatilizes at high temperature.

The aspect ratio can be determined by analyzing an electron microscopic image of the boron nitride particles with an image processing system. In the specification, the "aspect ratio" refers to a ratio of the length of the long axis (long dimension) to the length of the short axis (short dimension) (long dimension/short dimension).

The method for preparing the boron nitride particles is not particularly limited, and the particles can be prepared by an ordinary method. Examples of the method include, but not limited thereto, a method of heating a boron powder under a nitrogen flow to 1500°C or higher; a method of allowing melted boric anhydride to react with nitrogen or ammonia in the presence of calcium phosphate; a method of allowing boric acid or an alkaline borate to react with an organic nitrogen compound such as urea, guanidine or melamine in a nitrogen-ammonia atmosphere at high temperature; a method of allowing melted sodium borate to react with ammonium chloride in an ammonia atmosphere; and a method of allowing boron trichloride to react with ammonia at high temperature. Among these methods, a method of allowing boron trichloride to react with ammonia at high temperature is preferred in view of obtaining highly pure boron nitride.

The boron nitride particles may be subjected to mechanical surface modification so as to control the average primary particle diameter and the volume average secondary particle diameter. Examples of the mechanical surface modification include pulverization and a surface modification for changing the physicochemical state of the surface of the particles. Among these, pulverization is preferred. By performing pulverization, the average primary particle diameter of the boron nitride particles can be reduced. In addition, the boron nitride particles that have been subjected to pulverization tend to exhibit improved diffusivity even if the boron nitride particles have a high crystallinity. The mechanical surface modification may be a single process or a combination of two or more processes, if necessary.

Examples of the method for pulverization include dry milling and wet milling. From the viewpoint of adjustability of diffusivity and reactivity with a semiconductor substrate, wet milling is preferred.

The material of a milling vessel, beads, balls and the like that are used for the milling is preferably appropriately selected from materials that suppress incorporation of impurities due to a milling apparatus during milling and is less likely to diminish the dopant properties. Specifically, the materials include nylon, alumina, and partially-stabilized zirconia.

In the dry milling, for example, a jet mill, a vibratory mill, a ball mill or the like can be used.

In the wet milling, a bead mill, a ball mill or the like can be used. In particular, the bead mill is preferred.

The conditions for the pulverization are not limited and may be appropriately selected according to the milling apparatus to be used, the dispersion medium to be used, and the like, such that the average secondary particle diameter of the boron nitride particles can be controlled to be within the above range.

In the wet milling, the dispersion medium is not particularly limited and may be water, an organic solvent, or a combination thereof. In particular, the dispersion medium is preferably water. In that case, the purity can be readily controlled and pulverization of boron nitride can be readily carried out. In a case in which the dispersion medium used in the pulverization is different from the dispersion medium included in the composition for forming a p-type diffusion layer, the particles can be dried after the pulverization to remove the dispersion medium, and then a dispersion medium as described below can be used.

Specific examples of the dispersion medium include ketone solvents such as acetone, methyl ethyl ketone, methyl n-propyl ketone, methyl isopropyl ketone, methyl n-butyl ketone, methyl isobutyl ketone, methyl n-pentyl ketone, methyl n-hexyl ketone, diethyl ketone, dipropyl ketone, diisobutyl ketone, trimethyl nonanone, cyclohexanone, cyclopentanone, methyl cyclohexanone, 2,4-pentanedione, and acetonylacetone;
ether solvents such as diethyl ether, methyl ethyl ether, methyl n-propyl ether, diisopropyl ether, tetrahydrofuran, methyl tetrahydrofuran, dioxane, dimethyl dioxane, ethylene glycol dimethyl ether, ethylene glycol diethyl ether, ethylene glycol di-n-propyl ether, ethylene glycol dibutyl ether, diethylene glycol dimethyl ether, diethylene glycol diethyl ether, diethylene glycol methyl ethyl ether, diethylene glycol methyl n-propyl ether, diethylene glycol methyl n-butyl ether, diethylene glycol di-n-propyl ether, diethylene glycol di-n-butyl ether, diethylene glycol methyl n-hexyl ether, triethylene glycol dimethyl ether, triethylene glycol diethyl ether, triethylene glycol methyl ethyl ether, triethylene glycol methyl n-butyl ether, triethylene glycol di-n-butyl ether, triethylene glycol methyl n-hexyl ether, tetraethylene glycol dimethyl ether, tetraethylene glycol diethyl ether, tetraethylene glycol methyl ethyl ether, tetraethylene glycol methyl n-butyl ether, diethylene glycol di-n-butyl ether, tetraethylene glycol methyl n-hexyl ether, tetraethylene glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methyl ethyl ether, dipropylene glycol methyl n-butyl ether, dipropylene glycol di-n-propyl ether, dipropylene glycol di-n-butyl ether, dipropylene glycol methyl n-hexyl ether, tripropylene glycol dimethyl ether, tripropylene glycol diethyl ether, tripropylene glycol methyl ethyl ether, tripropylene glycol methyl n-butyl ether, tripropylene glycol di-n-butyl ether, tripropylene glycol methyl n-hexyl ether, tetrapropylene glycol dimethyl ether, tetrapropylene glycol diethyl ether, tetrapropylene glycol methyl ethyl ether, tetrapropylene glycol methyl n-butyl ether, dipropylene glycol di-n-butyl ether, tetrapropylene glycol methyl n-hexyl ether, and tetrapropylene glycol di-n-butyl ether;
ester solvents such as methyl acetate, ethyl acetate, n-propyl acetate, i-propyl acetate, n-butyl acetate, i-butyl acetate, sec-butyl acetate, n-pentyl acetate, sec-pentyl acetate, 3-methoxy butyl acetate, methyl pentyl acetate, 2-ethyl butyl acetate, 2-ethyl hexyl acetate, 2-(2-butoxyethoxy)ethyl acetate, benzyl acetate, cyclohexyl acetate, methyl cyclohexyl acetate, nonyl acetate, methyl acetoacetate, ethyl acetoacetate, diethylene glycol methyl ether acetate, diethylene glycol monoethyl ether acetate, dipropylene glycol methyl ether acetate, dipropylene glycol ethyl ether acetate, glycol diacetate, methoxy triglycol acetate, ethyl propionate, n-butyl propionate, i-amyl propionate, diethyl oxalate, di-n-butyl oxalate, methyl lactate, ethyl lactate, n-butyl lactate, n-amyl lactate, ethylene glycol methyl ether propionate, ethylene glycol ethyl ether propionate, ethylene glycol methyl ether acetate, ethylene glycol ethyl ether acetate, propylene glycol methyl ether acetate, propylene glycol ethyl ether acetate, propylene glycol propyl ether acetate, γ-butyrolactone, and γ-valerolactone;
aprotic polar solvents such as acetonitrile, N-methyl pyrrolidinone, N-ethyl pyrrolidinone, N-propyl pyrrolidinone, N-butyl pyrrolidinone, N-hexyl pyrrolidinone, N-cyclohexyl pyrrolidinone, N,N-dimethyl formamide, N,N-dimethyl acetamide, and dimethyl sulfoxide;
alcohol solvents such as methanol, ethanol, n-propanol, i-propanol, n-butanol, i-butanol, sec-butanol, t-butanol, n-pentanol, i-pentanol, 2-methyl butanol, sec-pentanol, t-pentanol, 3-methoxy butanol, n-hexanol, 2-methyl pentanol, sec-hexanol, 2-ethyl butanol, sec-heptanol, n-octanol, 2-ethyl hexanol, sec-octanol, n-nonyl alcohol, n-decanol, sec-undecyl alcohol, trimethyl nonyl alcohol, sec-tetradecyl alcohol, sec-heptadecyl alcohol, phenol, cyclohexanol, methyl cyclohexanol, benzyl alcohol, ethylene glycol, 1,2-propylene glycol, 1,3-butylene glycol, diethylene glycol, dipropylene glycol, triethylene glycol, and tripropylene glycol;
glycol monoether solvents such as ethylene glycol monomethyl ether, ethylene glycol monoethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxy triglycol, tetraethylene glycol mono-n-butyl ether, propylene glycol monomethyl ether, dipropylene glycol monomethyl ether, dipropylene glycol monoethyl ether, and tripropylene glycol monomethyl ether; and
terpene solvents such as α-terpinene, α-terpineol, myrcene, allo-ocimene, limonene, dipentene, α-pinene, β-pinene, terpineol, carvone, ocimene, and phellandrene. These solvents may be used alone or in combination of two or more thereof.

The method for surface modification may be any dry modification method in which a surface of micro particles is modified or complexed with a known surface modification apparatus. In this way, diffusivity of boron nitride can be improved even if the boron nitride has a high crystallinity.

The surface modification apparatus may be selected from known apparatuses. Examples of the apparatus include MECHANOFUSION and NOBILTA from Hosokawa Micron Corporation; and a hybridizer from Nara Machinery Co., Ltd.

The conditions for surface modification are not particularly limited, and can be appropriately selected according to the pulverization apparatus to be used, the dispersion medium to be used, and the like, such that the average primary particle diameter of the boron nitride can be controlled to be within the above range.

The purity of boron nitride is preferably higher, and 99% by mass or more is preferred. In particular, by lowering the content of an impurity element other than boron nitride such as Fe, Cr, Ni, Cu, W or Mn, it is possible to suppress more efficiently a decrease in power generation efficiency of a photovoltaic cell element produced by using the composition for forming a p-type diffusion layer.

Examples of the boron compound other than boron nitride include boron oxide, boric acid, alkyl boronic acid ester, tetraalkyl borate, tetraphenyl borate, borane, boronic acid, and boron chloride.

In a case in which the composition for forming a p-type diffusion layer includes a boron compound other than boron nitride, the content thereof is not particularly limited and preferably 100% by mass or less, more preferably 30% by mass or less, and still more preferably 1% by mass or less, with respect to boron nitride.

The boron compound other than boron nitride may be deposited on a surface of boron nitride. In that case, boron oxide or the like may be used as the boron compound.

Preferably, the boron nitride is boron nitride particles that have an oxygen atom content of 15% by mass. More specifically, the boron nitride is preferably boron nitride particles that include boron nitride and an oxide derived from boron nitride, and have an oxygen content of 15% by mass or less.

If the oxygen content of the boron nitride particles is within the specified range, the particles may exhibit an excellent diffusivity, and reaction of the composition for forming a p-type diffusion layer with a substrate at high temperature can be inhibited, whereby a p-type diffusion layer having a low resistance can be formed. Further, warpage of the silicon substrate during the thermal diffusion can be prevented.

Whether the boron nitride particles include boron nitride as a component can be determined by identifying the presence of peaks derived from boron nitride by powder X-ray diffraction or the like.

The oxygen content of the boron nitride particles is preferably from 0.3% by mass to 5.0% by mass, more preferably from 1.2% by mass to 2.0% by mass. If the oxygen content of the boron nitride particles is more than 15% by mass, the particles may not attain sufficient diffusivity. Further, in that case, since the amount of an oxide derived from boron nitride (such as boron oxide) that exists on the surface of the boron nitride particles is increased, properties such as moisture absorption due to the oxide may become relatively strong as the total boron nitride particles. Therefore, properties such as chemical stability that derive from boron nitride may become relatively weak.

The oxygen content of the boron nitride particles can be determined by an inert gas fusion and infrared absorption method with a commercially available oxygen-and-nitrogen analyzer. Examples of the oxygen-and-nitrogen analyzer include an oxygen-and-nitrogen analyzer from LECO Corporation, and a high accuracy oxygen-and-nitrogen analyzer for a solid sample from Horiba, Ltd.

The oxide derived from boron nitride is not limited as long as the oxide is a compound formed by oxidization of boron nitride, and may be an oxide obtained by oxidizing boron nitride or an oxide that is included in commercially available boron nitride particles as an impurity. Specific examples include boron oxide and an oxide derived from silicon boride (for example, silicon oxide that includes boron). Among these, boron oxide is preferred.

The oxide may be included on the surface of the boron nitride particles or inside of the particles. Preferably, the oxide is included at least at the surface of the boron nitride particles, in view of diffusivity of boron atoms.

The method for producing the boron nitride particles that include an oxide derived from boron nitride is not particularly limited. Examples of the method include a method of oxidizing the surface of boron nitride particles; a method of applying an oxide derived from boron nitride to the surface of boron nitride particles; and a method of forming boron nitride particles from boron nitride and an oxide derived from boron nitride. In particular, a method of oxidizing the surface of boron nitride particles is preferred in view of diffusivity of boron atoms and chemical stability of the particles.

By subjecting only the surface of the particles to an oxidation treatment, it is possible to achieve a higher chemical stability due to boron nitride, and a higher diffusivity due to the oxide (preferably, boron oxide).

The oxygen content of highly pure boron nitride particles that are commonly commercially available have an oxygen content of 1.0% by mass or less. In the present invention, it is preferred to adjust the oxygen content of the boron nitride particles to a desired range by subjecting the surface of the particles to an oxidation treatment. By adjusting the oxygen content to be within the desired range, an N-O group, a B-O group or the like tends to be formed on the surface of the particles. It is thought that boron nitride particles that include a B-O group on the surface tend to allow a boron-containing gas to volatilize at high temperature more easily, thereby further improving diffusivity.

Examples of the method of oxidizing the surface of the boron nitride particles include a method of oxidizing the surface of boron nitride particles by performing mechanical surface modification; a method of oxidizing the surface of boron nitride particles by performing a thermal treatment in the presence of oxygen; and a method of subjecting the surface of boron nitride particles to an oxygen plasma treatment. In particular, from the viewpoint of diffusivity of boron atoms, a method of performing mechanical surface modification or a method of performing a thermal treatment is preferred, and a method of performing mechanical surface modification is more preferred.

A preferred example of the method for subjecting the boron nitride particles to a thermal treatment is a method of heating the boron nitride particles in an atmosphere including oxygen at high temperature. By adjusting appropriately the temperature and the time of the thermal treatment, the oxygen content of the boron nitride particles can be adjusted to be within the desired range.

The temperature for the thermal treatment is preferably 900°C or higher, more preferably from 900°C to 1150°C, and still more preferably from 950°C to 1050°C. If the temperature for the thermal treatment is 900°C or higher, the surface of the boron nitride particles is efficiently oxidized, and an effect of oxidation treatment is readily attained. If the temperature for the thermal treatment is 1150°C or less, the speed of oxidization of the surface of the boron nitride particles can be prevented from becoming too rapid, and the treatment time can be readily regulated.

The time for the thermal treatment time is not particularly limited, and may be appropriately selected according to the desired oxygen content and the thermal treatment temperature. For example, the treatment time is preferably from 5 minutes to 120 minutes, more preferably from 10 minutes to 60 minutes. If the time is 5 minutes or more, the variation in oxygen content of the particles tends to be suppressed. If the treatment time is 120 minutes or less, an increase in production costs tends to be suppressed.

The oxygen content of the atmosphere employed in the thermal treatment is not particularly limited. For example, the oxygen content may be from 0.1% by volume to 100% by volume, more preferably from 1% by volume to 30% by volume.

Preferably, the surface of the boron nitride particles is subjected to an oxidation treatment by performing mechanical surface modification. In the specification, the "mechanical surface modification" refers to a process of modifying the physicochemical state of the surface of the particles by a method of pulverizing the boron nitride particles or a method of applying a shearing force to the boron nitride particles. In particular, pulverization as described above is preferred.

From the viewpoint of readily adjusting the oxygen content, the pulverization is preferably a wet milling treatment. The dispersion medium used in a wet milling treatment is not particularly limited, and may be water, a solvent, or a combination thereof. The details of the solvent are as described above. If pulverization is performed by a dry method, there may be a case in which oxidation is promoted and the oxygen content is not readily adjusted.

The content of boron nitride in the composition for forming a p-type diffusion layer is determined depending on application suitability, diffusivity of boron, and the like. Generally, the content of boron nitride in the composition for forming a p-type diffusion layer is preferably from 5% by mass to 80% by mass, more preferably from 10% by mass to 60% by mass, and still more preferably from 15% by mass to 40% by mass. If the composition includes boron nitride in an amount of 5% by mass or more, a sufficient boron diffusivity tends to be attained and the resistance of the substrate tends to be readily lowered. If the composition includes boron nitride in an amount of 60% by mass or less, it tends to be easy to apply the composition for forming a p-type diffusion layer uniformly.

### (B) Dispersion medium

The composition for forming a p-type diffusion layer of the present invention includes a dispersion medium. By including a dispersion medium, it becomes possible to form a p-type diffusion layer into a desired shape more efficiently.

The dispersion medium refers to a medium that allows the boron compound to disperse in the composition. Specifically, the dispersion medium includes at least a solvent and a fluid medium such as water, and, if necessary, an organic binder.

Examples of the solvent include the solvents as described above in connection with the pulverization.

Preferred examples of the solvent for the composition for forming a p-type diffusion layer include α-terpineol, diethylene glycol mono-n-butyl ether, and diethylene glycol mono-n-butyl ether acetate, in view of application suitability with respect to a substrate, and suitable solvents include α-terpineol and diethylene glycol mono-n-butyl ether. The solvents may be used alone or in combination of two or more thereof.

The content of the solvent in the composition for forming a p-type diffusion layer is not particularly limited, and may be appropriately adjusted according to the desired viscosity of the composition. For example, the composition for forming a p-type diffusion layer may include a solvent in an amount of from 10% by mass to 93.5% by mass, preferably from 50% by mass to 90% by mass.

### (C) Organic Binder

The dispersion medium preferably includes at least one organic binder. The organic binder is used for binding boron nitride particles, for example.

Examples of the organic binder include polyvinyl alcohol, polyacrylamides, polyvinylamides, polyvinyl pyrrolidone, polyethylene oxides, polysulfonic acid, acrylamide alkyl sulfonic acid, cellulose, cellulose derivatives such as cellulose ethers, carboxymethyl cellulose, hydroxyethyl cellulose and ethyl cellulose, gelatin and gelatin derivatives, starch and starch derivatives, sodium alginates, xanthan and xanthan derivatives, guar and guar derivatives, scleroglucan and scleroglucan derivatives, tragacanth and tragacanth derivatives, dextrin and dextrin derivatives, (meth)acrylic acid resins, (meth)acrylic acid ester resins (such as alkyl (meth)acrylate resins, dimethylaminoethyl (meth)acrylate resins), butadiene resins, styrene resins, polyvinyl acetal resins, polyvinyl chloride resins, and copolymers thereof. The organic binders may be appropriately selected from these binders. The organic binder may be used alone or in combination of two or more thereof.

In particular, the dispersion medium preferably includes at least one organic binder selected from the group consisting of ethyl cellulose, polyvinyl acetal resins, (meth)acrylic acid resins, hydroxyethyl cellulose, polyvinyl acetate and polyvinyl chloride resins, more preferably at least one selected from the group consisting of ethyl cellulose, polyvinyl acetal resins and (meth)acrylic acid resins.

The molecular weight of the organic binder is not particularly limited, and may be appropriately adjusted according to the desired viscosity of the composition. For example, the organic binder may have an average mass molecular weight of from 10,000 to 500,000, preferably from 50,000 to 300,000.

The content of the organic binder in the dispersion medium is not particularly limited, and may be appropriately adjusted according to the desired viscosity of the composition for forming a p-type diffusion layer. For example, the dispersion medium may include the organic binder in an amount of from 0.5% by mass to 10% by mass based on the total mass of the composition for forming a p-type diffusion layer, preferably from 2% by mass to 8% by mass.

The composition and the content of the dispersion medium in the composition for forming a p-type diffusion layer may be determined depending on application suitability and boron concentration.

The dispersion medium used in the present invention preferably includes a solvent selected from α-terpineol, diethylene glycol mono-n-butyl ether, and diethylene glycol mono-n-butyl ether acetate in an amount of from 10% by mass to 93.5% by mass in the total mass of the composition for forming a p-type diffusion layer, and includes an organic binder selected from the group consisting of ethyl cellulose and polyvinyl alcohol in an amount of from 0.5% by mass to 10% by mass in the total mass of the composition for forming a p-type diffusion layer. More preferably, the dispersion medium includes a solvent selected from α-terpineol and diethylene glycol mono-n-butyl ether in an amount of from 10% by mass to 93.5% by mass in the total mass of the composition for forming a p-type diffusion layer, and includes at least one organic binder selected from the group consisting of ethyl cellulose and polyvinyl alcohol in an amount of from 0.5% by mass to 10% by mass in the total mass of the composition for forming a p-type diffusion layer.

### (D) Inorganic Binder

The composition for forming a p-type diffusion layer includes at least one inorganic binder. The inorganic binder refers to a compound that includes at least one metal element and serves to bind boron nitride in the thermal diffusion process, thereby suppressing scattering of boron nitride. In a case in which the composition for forming a p-type diffusion layer includes an inorganic binder, decomposition of an organic binder that is optionally added may be suppressed in the thermal diffusion process for diffusing boron nitride as a dopant compound, whereby scattering of boron nitride is suppressed and contamination of the apparatus is prevented.

The inorganic binder is not particularly limited as long as it can bind boron nitride at a temperature of 500°C or higher. Examples of the inorganic binder include an organic metal compound and a glass frit. The inorganic binder may be used alone or in combination of two or more kinds.

The organic metal compound is preferably at least one selected from the group consisting of a metal alkoxide, a silicone resin and a silane coupling agent.

### «Metal Alkoxide»

A metal alkoxide is a compound formed by reaction of a metal atom with alcohol, and is represented by the following formula (1):

M(OR¹)ₐ (1)

In formula (1), M is a metal element that has a valence of 1 to 7 and is selected from the group consisting of Li, Na, K, Mg, Ca, Sr, Ba, La, Ti, B, Zr, Hf, V, Nb, Ta, Cr, Mo, W, Mn, Fe, Co, Ni, Cu, Zn, Pb, Bi and Si. From the viewpoint of power generation efficiency of a photovoltaic cell element, M is preferably a metal atom selected from the group consisting of Li, Na, K, Mg, Ca, Sr, Ba, La, Ti, B, Zr, Hf, V, Nb, Ta, Mo, Co, Zn, Pb, Bi and Si, more preferably a metal atom selected from the group consisting of Si, Mg, Ca and Ti. R¹ is an alcohol residue from which an OH group is removed.

Suitable examples of the alcohol that forms the metal alkoxide include an alcohol represented by the following formula (2).

R¹OH (2)

In formula (2), R¹ represents a saturated or unsaturated hydrocarbon group having a carbon number of 1 to 6, or a hydrocarbon group substituted with an alkoxy group having a carbon number of 1 to 6.

In formula (2), if R¹ is a saturated or unsaturated hydrocarbon group substituted with an alkoxy group having a carbon number of 1 to 6, examples of the alcohol include methanol, ethanol, 1-propanol, 2-propanol, butanol, amylalcohol and cyclohexanol.

In formula (2), if R¹ is a hydrocarbon group substituted with an alkoxy group substituted with an alkoxy group having a carbon number of 1 to 6, examples of the alcohol include methoxy methanol, methoxy ethanol, ethoxy methanol, ethoxy ethanol, methoxy propanol, ethoxy propanol and propoxy propanol.

Among the metal alkoxides, a silicon alkoxide is preferred. By using a silicon alkoxide, a decrease in diffusivity of boron or contamination of a silicon substrate may be suppressed. Among silicon alkoxides, tetraethoxy silane or tetramethoxy silane is preferred. The silicon alkoxide may be combined with water and a catalyst, if necessary.

It is thought that the metal alkoxide binds boron nitride while it changes to, for example, a silicon oxide during the process of thermally diffusing boron that is usually carried out at a temperature of 800°C or higher.

### «Silane Coupling Agent»

The structure of the silane coupling agent is not particularly limited, and examples thereof include those represented by the following formula (3):

XₙR²₍₃₋ₙ₎SiR¹-Y (3)

In formula (3), X represents a methoxy group or an ethoxy group. Y represents a vinyl group, a mercapto group, an epoxy group, an amino group, a (meth)acryloyl group, a glycidoxy group, an ureido group, a sulfide group or a (meth)acryloxy group. Y is preferably a vinyl group, an amino group, an epoxy group or a mercapto group, more preferably an amino group.

In formula (3), R¹ represents an alkylene group that has a carbon number of 2 to 10 or a divalent linking group that has a main chain of 2 to 5 atoms and a nitrogen atom in the main chain. The alkylene group is preferably an ethylene group or a propylene group. The atomic group that includes a nitrogen atom in the linking group is preferably an amino group.

In formula (3), R² represents an alkyl group having a carbon number of 1 to 5. The alkyl group is preferably a methyl group or an ethyl group, more preferably a methyl group. In formula (3), n represents an integer of 1 to 3.

Specific examples of the silane coupling agent include the silane coupling agents of the following groups (a) to (c):
(a) a silane coupling agent having an epoxy group or a glycidoxy group, such as 3-glycidoxy propyl trimethoxy silane, 3-glycidoxy propyl methyl dimethoxy silane, and 2-(3,4-epoxy cyclohexyl)ethyl trimethoxy silane;
(b) a silane coupling agent having an amino group, such as N-(2-aminoethyl)3-aminopropyl methyl dimethoxy silane, N-(aminoethyl)3-aminopropyl trimethoxy silane, and 3-aminopropyl triethoxy silane; and
(c) a silane coupling agent having a mercapto group, such as 3-mercaptopropyl trimethoxy silane.

### «Silicone Resin»

The silicone resin is not particularly limited and may be, for example, a thermosetting silicone resin or a thermodecomposable silicone resin. The organic group on the silicon atom that forms a silicone resin is not particularly limited, and examples thereof include a phenyl group, an alkyl group, a polyether, an epoxy group, an amino group, a carboxy group, an aralkyl group, and a fluoroalkyl group.

The molecular weight of the silicone resin is not particularly limited, and is preferably from 100 to 100,000, more preferably from 1,000 to 50,000.

### «Glass Frit»

The glass frit is not particularly limited, and may be a glass frit that includes boron or a glass frit that does not include boron. It is possible to control the properties of the glass frit such as a melting temperature, a softening point, a glass transition point, chemical durability or the like by adjusting the component ratio, if necessary. Preferably, the glass frit includes a glass component substance as described below.

Examples of the glass component substance include SiO₂, K₂O, Na₂O, Li₂O, BaO, SrO, CaO, MgO, BeO, ZnO, PbO, CdO, V₂O₅, SnO, ZrO₂, WO₃, MoO₃, MnO, La₂O₃, Nb₂O₅, Ta₂O₅, Y₂O₃, TiO₂, GeO₂, TeO₂ and Lu₂O₃. The glass component substance is preferably at least one selected from the group consisting of SiO₂, K₂O, Na₂O, Li₂O, BaO, SrO, CaO, MgO, BeO, ZnO, PbO, CdO, SnO, ZrO₂ and MoO₃.

Specific examples of the glass frit that includes boron include glass frits of B₂O₃-SiO₂, B₂O₃-ZnO, B₂O₃-PbO and B₂O₃-CaO. Although the aforementioned examples include two-component composite glasses, the glass frit may include three or more components, such as B₂O₃-SiO₂-CaO. In particular, a glass frit of B₂O₃-SiO₂ (borosilicate) is preferred.

Specific examples of the glass frit that does not include boron include glass frits of SiO₂-ZnO, SiO₂-CaO and CaO-ZnO. Although the aforementioned examples include two-component composite glasses, the glass frit may include three or more components, such as SiO₂-CaO-ZnO.

Examples of the shape of the glass frit include a near spherical shape, a flat shape, a blocky shape, a platelet shape and a flaky shape. In consideration of application suitability with respect to a substrate and uniform diffusivity of the composition for forming a p-type diffusion layer, the glass frit preferably has a near spherical shape, a flat shape or a platelet shape. The glass frit has a particle diameter of 50 µm or less. If a glass frit having a particle diameter of 50 µm or less is used, a flat and smooth coating tends to be obtained. The particle diameter of the glass frit is more preferably 10 µm or less. The lower limit of the particle diameter is not particularly limited, but is preferably 0.01 µm or more, more preferably 0.1 µm or more. In the specification, the particle diameter of the glass frit refers to a volume average particle diameter. The volume average particle diameter can be measured with, for example, a laser scattering diffraction particle diameter distribution analyzer.

The composition for forming a p-type diffusion layer preferably includes an inorganic binder in an amount of from 1% by mass to 40% by mass, more preferably from 3% by mass to 20% by mass, and still more preferably from 5% by mass to 15% by mass. If the composition includes an inorganic binder in an amount of 1 % by mass or more, the binder tends to exert a sufficient ability to bind the boron nitride powder at a high temperature of 500°C or higher. If the composition includes the inorganic binder in an amount of 40% by mass or less, the viscosity of the composition for forming a p-type diffusion layer can be readily adjusted, whereby printability or jettability during inkjet printing tends to become favorable.

The viscosity of the composition for forming a p-type diffusion layer is not particularly limited, and may be appropriately adjusted in consideration of application suitability with respect to a silicon substrate, or the like. For example, the composition for forming a p-type diffusion layer may have a viscosity at 25°C of from 10 mPa·s to 10,000 Pa·s, preferably from 1 Pa·s to 1,000 Pa·s.

The viscosity of the composition for forming a p-type diffusion layer is measured at 25°C with an E type viscometer (cone-and-plate type viscometer, rotation number: 50 rpm).

### (E) Other Components

In addition to the boron nitride and the dispersion medium, the composition for forming a p-type diffusion layer may include, if necessary, other component(s) such as a silicon-containing material, a pro-oxidant, a viscosity enhancer, an wetting agent, and additives of various kinds. Examples of the other components include a surfactant, an inorganic powder, an organic boron compound and a thixotropic agent.

Examples of the surfactant include a nonionic surfactant, a cationic surfactant and an anionic surfactant. In particular, a nonionic surfactant or a cationic surfactant is preferred because the amount of impurities such as alkali metal or heavy metal introduced into a semiconductor device by the surfactant is small. Examples of the nonionic surfactant include a silicon surfactant, a fluorosurfactant and a hydrocarbon surfactant. Among these, a hydrocarbon surfactant is preferred in view of achieving rapid sintering during a thermal treatment such as a diffusion process.

Examples of the hydrocarbon surfactant include a block copolymer of ethylene oxide and propylene oxide, and an acetylene glycol compound. The acetylene glycol compound is more preferred, because the amount of variation in the resistance of a p-type diffusion layer that can be reduced by the acetylene glycol compound is greater than other compounds.

The inorganic powder may function as a filler. Specific examples of the inorganic powder include silicon oxide, titanium oxide, aluminum oxide, silicon nitride and silicon carbide.

The organic boron compound and the molecular structure thereof are not particularly limited, as long as the compound includes 10 or more boron atoms in the molecule.

The composition for forming a p-type diffusion layer may include an additive that has a possibility of reducing a boron compound. Examples of the additive include polyalkylene glycols such as polyethylene glycol and polypropylene glycol, and terminally alkylated derivatives thereof; monosaccharides such as glucose, fructose and galactose, and derivatives thereof; disaccharides such as sucrose and maltose, and derivatives thereof; and polysaccharides and derivatives thereof. Among these additives, polyalkylene glycol is preferred, and polypropylene glycol is more preferred.

By adding an additive that reduces a boron compound, it tends to become easy to diffuse boron into a silicon substrate.

The composition for forming a p-type diffusion layer may include a thixotropic agent. By including a thixotropic agent, a paste composition having a viscosity that is suitable for screen printing may be obtained. Further, by controlling thixotropy, bleeding or dripping from a printed pattern formed from the paste composition can be suppressed.

Examples of the thixotropic agent include organic particles that do not dissolve in the dispersion medium. The organic particles are not particularly limited, and examples of the organic particles include organic particles formed of polyethylene glycol or terminally-crosslinked polypropylene diglycidyl ether. In particular, organic particles formed of polyethylene glycol are preferred.

### <Method of producing silicon substrate having p-type diffusion layer and photovoltaic cell element>

The method of producing a silicon substrate having a p-type diffusion layer and the method of producing a photovoltaic cell element are described. Although a method in which a p-type silicon substrate is used is described below, the invention is also applicable to a method in which an n-type silicon substrate is used.

First, a damage layer is removed from a p-type silicon substrate by applying an alkali solution, and a texture structure is obtained by etching.

More specifically, a damage layer that is formed on a silicon surface during slicing from an ingot is removed with caustic soda (20% by mass). Subsequently, etching is performed with a mixed solution of caustic soda (1% by mass) and isopropyl alcohol (10% by mass), thereby forming a texture structure. By forming a texture structure on the light-receiving side (front surface), the light trapping effect of a photovoltaic cell element is promoted and the efficiency is increased.

Next, an n-type diffusion layer is uniformly formed by performing a treatment in an atmosphere of a mixed gas of phosphorus oxychloride (POCl₃), nitrogen and oxygen, at from 800 °C to 900 °C for several ten minutes. In a method in which a phosphorus oxychloride atmosphere is used, diffusion of phosphorus occurs not only at a front surface but at side surfaces and a back surface, and an n-type diffusion layer is formed not only on a front surface but also on side surfaces and a back surface. Therefore, a side etching treatment is performed in order to remove n-type diffusion layers formed on the side surfaces.

Then, the composition for forming a p-type diffusion layer is applied to the n-type diffusion layer on the back surface (i.e., opposite to the light-receiving surface) of the p-type silicon substrate. In the invention, the method for application is not limited and examples thereof include a printing method, a spin method, brush coating, a spray method, a doctor blade method, a roll coater method and an inkjet method.

The amount of application of the composition for forming a p-type diffusion layer is not particularly limited. For example, the amount of boron nitride is preferably from 0.05 g/cm² to 10 g/cm², more preferably from 0.01 g/cm² to 100 g/m². By increasing the amount of application, diffusion of boron into the silicon substrate tends to become easy.

Depending on the composition of the composition for forming a p-type diffusion layer, there are cases in which it is preferred to provide a drying process after the application, in order to evaporate a solvent included in the composition. The drying is performed at a temperature of approximately from 80°C to 300°C for approximately from 1 minute to 10 minutes (with a hot plate) or approximately from 10 minutes to 30 minutes (with a drying machine or the like). The conditions for drying can be selected as appropriate depending on the composition of the solvent in the composition for forming a p-type diffusion layer, and the invention is not limited to the conditions as mentioned above. It is also possible to form two or more layers by performing a process of applying the composition for forming a p-type diffusion layer and a process of drying twice or more, respectively. If two or more p-type diffusion layers are formed, resistance after the thermal treatment and etching tends to become low.

The silicon substrate onto which the composition for forming a p-type diffusion layer has been applied is subjected to a thermal treatment in an oxygen-containing atmosphere or under a flow of an oxygen-containing gas (for example, air) at a temperature of from 200°C to 800°C, for example, or preferably from 400°C to 600°C. By performing a thermal treatment, most of the dispersion medium can be removed and a p-type diffusion layer having more favorable performances can be formed.

Subsequently, the silicon substrate onto which the composition for forming a p-type diffusion layer has been applied is subjected to a thermal treatment at a temperature of from 600°C to 1250°C, for example, or preferably from 800°C to 1050°C. By performing the thermal treatment, boron is diffused into the silicon substrate and a p⁺-type diffusion layer is formed. The thermal treatment can be performed with a known continuous furnace, a batch furnace or the like. In the thermal diffusion atmosphere during the thermal treatment, the concentration of oxygen is preferably less than 5% by volume.

If the thermal treatment temperature is 600°C or higher, diffusion of boron is sufficiently carried out and a sufficient BSF effect can be attained. If the temperature is 1250°C or less, deterioration of the substrate can be suppressed.

It is also possible to perform the thermal treatment for forming a p-type diffusion layer by rapid thermal processing (RTP).

In a case in which a layer of a heat-treated product, such as a glass layer, is formed on the surface of the p-type diffusion layer after the thermal treatment, the glass layer or the like is removed by etching. The etching can be performed by a known method, such as a method of dipping in an acid such as hydrofluoric acid or a method of dipping in an alkali such as caustic soda. After the etching, it is preferred to perform ultrasonic washing or the like in order to remove the surplus of the boron compound.

In the conventional production method, an aluminum paste is applied to a back surface by printing, and the aluminum paste is sintered in order to convert the n-type diffusion layer to a p-type diffusion layer and also attain an ohmic contact. However, since an aluminum layer formed from the aluminum paste is low in conductivity, the aluminum layer formed on the entire region of the back surface typically needs to have a thickness of from 10 µm to 20 µm after sintering. Further, since the thermal conductivity of silicon and the thermal conductivity of aluminum are significantly different, a large internal stress may be generated in the silicon substrate and warpage may be caused.

The internal stress may damage the crystal grain boundary of silicon crystal, and may cause power loss. The warpage makes the photovoltaic cell element easy to brake during conveyance or connecting with a copper line referred to as a tab line, in a module process. In recent years, the thickness of the silicon substrate tends to decrease and the photovoltaic cell element tends to brake due to improvement in slicing techniques.

However, according to the method of the invention, an n-type diffusion layer is converted to a p-type diffusion layer by the composition for forming a p-type diffusion layer, and then an electrode is formed on the p-type diffusion layer. Therefore, the material for an electrode for a back surface is not limited to aluminum, and Ag (silver), Cu (copper) or the like can be used, for example. Further, the thickness of the electrode on the back surface can be reduced as compared with the conventional electrode, and the electrode needs not to be formed on the entire region of the back surface. Accordingly, it is possible to suppress generation of an internal stress in a silicon substrate during sintering or cooling, and to suppress warpage of the silicon substrate.

An antireflection film is formed on the n-type diffusion layer. The antireflection film is formed by a known technique. For example, in a case in which the antireflection film is a silicon nitride film, the antireflection film is formed by a plasma CVD method from a mixed gas of SiH₄ and NH₃ as a raw material. During the formation of the antireflection film, hydrogen is diffused into crystals and bonded to dangling bonds, i.e., an orbit that does not contribute to bonding with silicon atoms, whereby defects are inactivated (hydrogen-passivated).

More specifically, the antireflection film is formed under the conditions of a ratio of flow of the mixed gas (NH₃/SiH₄) of from 0.05 to 1.0, a pressure in a chamber of from 13.3 Pa (0.1 Torr) to 266.6 Pa (2 Torr), a temperature during film formation of from 300°C to 550°C, and a frequency for plasma discharge of 100 kHz or more.

A metal paste layer for a front surface electrode is formed on the antireflection film formed on the front surface (light-receiving surface) by applying a metal paste for forming a front surface electrode by a screen printing method and drying the same. The metal paste for forming a front surface electrode includes metal particles and glass particles as essential components, and optionally an organic binder and other additives.

Subsequently, a metal paste layer for a back surface electrode is formed on the p-type diffusion layer on the back surface. As described above, the material or the method for forming the back surface electrode is not particularly limited. For example, a metal paste layer for forming a back surface electrode can be formed by applying a paste for forming a back surface electrode that includes metal such as aluminum, silver or copper, and drying the same. During this process, a silver paste layer for forming a silver electrode may be provided on a portion of the back surface of the photovoltaic cell element, for the purpose of connecting the same with another photovoltaic cell element during a module process.

A photovoltaic cell element is obtained by sintering the metal paste layers for electrodes formed on the front surface and the back surface. When the metal paste layers are sintered at from 600°C to 900°C for from several seconds to several minutes, the antireflection film, which is an insulating film, is molten by the glass particles included in the metal paste for an electrode at the front surface, and a surface of silicon is also partially molten, and the metal particles in the paste (for example, silver particles) form a contact portion with the silicon substrate and solidify. As a result, a front surface electrode and the silicon substrate are electrically connected with each other. This process is referred to as fire-through.

The shape of the front surface electrode is explained. The front surface electrode is formed from, for example, bass bar electrodes and finger electrodes that are positioned across the bass bar electrodes.

The surface electrode can be formed by, for example, screen printing with the metal paste for an electrode as mentioned above, plating with a material for an electrode, or evaporation of a material for an electrode by electron beam heating under high vacuum. The front surface electrode formed from bass bar electrodes and finger electrodes is generally known, and may be formed by a known method for forming bass bar electrodes and finger electrodes on the light-receiving surface.

In the method of producing a p-type diffusion layer and the method of producing a photovoltaic cell element, a mixed gas of phosphorus oxychloride (POCl₃), nitrogen and oxygen is used for forming an n-type diffusion layer in silicon that forms a p-type silicon substrate. However, it is also possible to form an n-type layer with a composition for forming an n-type diffusion layer. The composition for forming an n-type diffusion layer includes an element in the 15th Group such as P (phosphorus) or Sb (antimony) as a donor element.

In the method of forming an n-type diffusion layer with a composition for forming an n-type diffusion layer, first, a composition for forming an n-type diffusion layer is applied onto the light-receiving surface that is a front surface of a p-type silicon substrate, the composition for forming a p-type diffusion layer according to the invention is applied onto the back surface, and the silicon substrate is subjected to a thermal treatment at from 600°C to 1200°C. During the thermal treatment, at the front surface, a donor element is diffused into the p-type silicon substrate and an n-type diffusion layer is formed. At the back surface, boron is diffused and a p⁺-type diffusion layer is formed. Other processes are the same as the processes as described. A photovoltaic cell element is thus obtained.

Subsequently, the embodiments of the invention are explained with reference to the drawings.

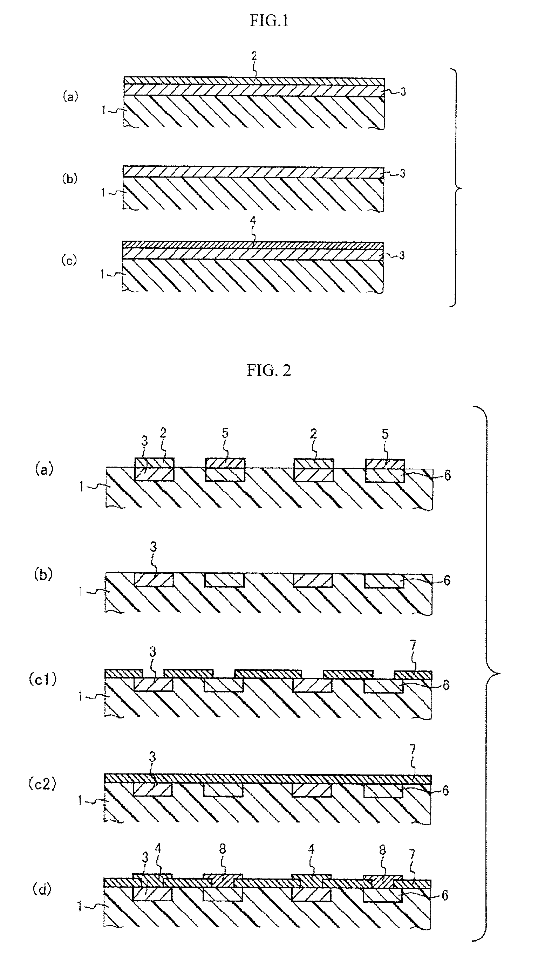

Fig. 1 illustrates an example of a process chart for producing a silicon substrate having a p⁺-type diffusion layer. It should be noted that the process chart does not limit the method of the invention.

On a surface of p-type silicon substrate 1, a composition for forming a p-type diffusion layer is applied and a composition layer for forming a p-type diffusion layer is formed. By subjecting the composition layer to a thermal treatment, p⁺-type diffusion layer 3 is formed in the vicinity of the surface of p-type silicon substrate 1. As shown in Fig. 1(a), p⁺-type diffusion layer 3 is formed in the vicinity of the surface of p-type silicon substrate 1. On p⁺-type diffusion layer 3, heat-treated product layer 2 of the composition for forming a p-type diffusion layer, such as a glass layer, is formed.

Subsequently, heat-treated product layer 2 of the composition for forming a p-type diffusion layer formed on p⁺-type diffusion layer 3 is removed by etching or the like. As shown in Fig.1 (b), heat-treated product layer 2 of the composition for forming a p-type diffusion layer as shown in Fig. 1 (a) is removed by etching, and p-type silicon substrate 1 having p⁺-type diffusion layer 3 formed in the vicinity of the surface of the p-type silicon substrate 1 is obtained.

As shown in Fig. 1(c), electrode 4 is formed on p⁺-type diffusion layer 3 of the p-type silicon substrate 1 by applying an electrode paste on p⁺-type diffusion layer 3 and performing a thermal treatment.

Fig. 2 illustrates a process chart in which an n-type diffusion layer and a p⁺-type diffusion layer are selectively formed at the same time. By selectively forming an n-type diffusion layer and a p⁺-type diffusion layer at the side opposite to the light-receiving surface, a back contact-type photovoltaic cell element is obtained.

By selectively applying a composition for forming a p-type diffusion layer and a composition for forming an n-type diffusion layer onto the surface of p-type silicon substrate 1, respectively, and performing a thermal treatment, p⁺-type diffusion layer 3 and n-type diffusion layer 6 are formed at specified regions, respectively. The application of a paste can be performed by an inkjet method or a pattern printing method.

As shown in Fig. 2(a), heat-treated product layer 2 of the composition for forming a p-type diffusion layer is formed on p⁺-diffusion layer 3 of p-type silicon substrate 1, and heat-treated product layer 5 of the composition for forming an n-type diffusion layer is formed on n-type diffusion layer 6.

Subsequently, heat-treated product layer 2 of the composition for forming a p-type diffusion layer that is formed on p⁺-diffusion layer 3 of p-type silicon substrate 1, and heat-treated product layer 5 of the composition for forming an n-type diffusion layer that is formed on n-type diffusion layer 6 are removed by etching or the like.

As shown in Fig. 2(b), p-type silicon substrate 1 having p⁺-type diffusion layer 3 and n-type diffusion layer 6 that are selectively formed in the vicinity of the surface is obtained, as a result of removing heat-treated product layer 2 of the composition for forming a p-type diffusion layer and heat-treated product layer 5 of the composition for forming an n-type diffusion layer as shown in Fig. 2(a).

Subsequently, antireflection film or surface protection layer 7 is formed on p-type silicon substrate 1 by a known method. It is possible to form antireflection film or surface protection layer 7 at portions such that p⁺-type diffusion layer 3 and n-type diffusion layer 6 are exposed, as shown in Fig. 2(c1).

It is also possible to form antireflection film or surface protection layer 7 on the entire surface of p-type silicon substrate 1.

Subsequently, an electrode paste is selectively applied onto p-type diffusion layer 3 and n-type diffusion layer 6 and subjected to a thermal treatment, and as shown in Fig. 2(d), electrode 4 and electrode 8 are formed on p-type diffusion layer 3 and n-type diffusion layer 6, respectively.

In a case in which an antireflection film or a surface protection film is formed on the entire surface of p-type silicon substrate 1, as shown in Fig. 2(c2), electrode 4 and electrode 8 can be formed on p-type diffusion layer 3 and n-type diffusion layer 6, respectively, by using a glass powder having a fire-through property as an electrode paste, as shown in Fig. 2(d).

Since a photovoltaic cell element produced by a method including the processes as shown in Fig. 2 does not have an electrode on the light-receiving surface, it can effectively take in solar light.

The embodiments as described above are explained as a case in which a p-type silicon substrate is used. However, it is also possible to produce a photovoltaic cell element with an n-type silicon substrate in a similar manner.

### <Method of producing silicon substrate having p-type diffusion layer that has selective emitter structure, and method of producing photovoltaic cell element>

The composition for forming a p-type diffusion layer may be used to produce a selective emitter structure, in which the dopant concentration of a diffusion layer at a selected region that is positioned immediately under an electrode, for the purpose of improving the connection of a diffusion layer and an electrode.

The method of producing a silicon substrate having a p-type diffusion layer that has a selective emitter structure include an application process in which the composition for forming a p-type diffusion layer is applied onto a silicon substrate by at least one method selected from the following (1) to (3); and a thermal diffusion treatment process in which the silicon substrate is heated.
(1) using at least two compositions for forming a p-type diffusion layer having different concentrations of boron nitride as the composition for forming a p-type diffusion layer, and applying, to the selected region, the composition for forming a p-type diffusion layer having a higher concentration of boron nitride;
(2) applying, to the selected region, the composition for forming a p-type diffusion layer more than once; and
(3) applying, to the selected region, the composition for forming a p-type diffusion layer that includes highly diffusive boron nitride.

In the method (1), at least two diffusing agents having different concentrations of boron nitride are used, and the diffusing agent having a higher concentration of boron nitride is applied to the selected region. The concentration of boron nitride in the diffusing agent is preferably adjusted depending on the desired amount of boron atoms to be diffused into the silicon substrate.

In the method (2), the diffusing agent is applied more than once at the selected region. The diffusing agent used for each application may be the same or different in boron nitride concentration. It is also possible to perform application and drying alternately. The application may be performed three or more times.

In the method (3), a diffusing agent that includes highly diffusive boron nitride is applied to the selected region. Examples of the highly diffusive boron nitride include boron nitride particles having a flat shape or a plate shape with a high aspect ratio; boron nitride particles having a crystalline form of hexagonal crystal; boron nitride particles that includes an oxide derived from boron nitride and a concentration of oxygen of 15% by mass or less; boron nitride particles having a small particle diameter; and boron nitride particles having a large surface area. Details of the highly diffusive boron nitride are described later.

In the method (3), the diffusing agent to be applied to a selected region and the diffusing agent to be applied to a region other than the selected region may be the same or different in boron nitride concentration, as mentioned in the method (1). Further, it is possible to apply a diffusing agent including highly diffusive boron nitride to the selected region more than once, in combination with the method (2).

The selective region may include regions of three or more different concentrations, for example, a selected region with a high concentration (p⁺⁺⁺-type diffusion layer), a selected region with a middle concentration (p⁺⁺-type diffusion layer) and a selected region with a low concentration (p⁺-type diffusion layer). According to the invention, it is possible to produce a selective emitter structure in a simple and effective manner by at least one of the methods (1) to (3) or a combination thereof.

The method of producing a silicon substrate having a p-type diffusion layer that has a selective emitter structure is explained. Although an n-type silicon substrate is used in the method as described below, the invention is applicable to a method in which a p-type silicon substrate is used. In the following, the composition for forming a p-type diffusion layer is also referred to a diffusing agent.

First, an alkali solution is applied to an n-type silicon substrate to remove a damage layer, and a texture structure is obtained by etching.

More specifically, a damage layer that is formed on a silicon surface during slicing from an ingot is removed with caustic soda (20% by mass). Subsequently, etching is performed with a mixed solution of caustic soda (1% by mass) and isopropyl alcohol (10% by mass), thereby forming a texture structure. By forming a texture structure at the light-receiving side (front surface), the light trapping effect of a photovoltaic cell element is promoted and the efficiency is increased.

Next, a diffusion agent that includes boron nitride and a dispersion medium is applied. The amount of application of the diffusing agent is not particularly limited. For example, the amount of boron nitride is preferably from 0.01 mg/cm² to 100 mg/cm², more preferably from 0.05 mg/cm² to 10 mg/cm². As the amount of application increases, it becomes easier to allow boron to diffuse into the silicon substrate.

Depending on the composition of the diffusing agent, there are cases in which it is preferred to provide a drying process after the application, in order to evaporate a solvent included in the composition. The drying is performed at a temperature of approximately from 80°C to 300°C for approximately from 1 minute to 10 minutes (with a hot plate) or approximately from 10 minutes to 30 minutes (with a drying machine or the like). The conditions for drying can be selected as appropriate depending on the composition of the solvent in the diffusing agent, and the invention is not limited to the conditions as mentioned above.

The method of application to a selected region and a region other than the selected region are as described above. At a portion at which an electrode is to be formed, the amount of diffusion of boron atoms per area is increased such that the portion is a selected region.

The silicon substrate onto which the diffusing agent has been applied is subjected to a thermal diffusion treatment in an atmosphere of a mixed gas of nitrogen and oxygen at a temperature of, for example, from 600°C to 1250°C, preferably from 800°C to 1050°C. By performing the thermal diffusion treatment, boron is diffused into the silicon substrate, thereby forming a p⁺-type diffusion layer, p⁺⁺-type diffusion layer or the like. If the thermal diffusion treatment temperature is 600°C or higher, diffusion of boron is sufficiently carried out and a sufficient BSF effect can be attained. If the temperature is 1250°C or less, deterioration of the substrate can be suppressed.

The time for the thermal diffusion treatment carried out at from 600°C to 1250°C is preferably adjusted depending on the amount of boron to be diffused or the like, and may be, for example, from 5 minutes to 120 minutes, more preferably from 10 minutes to 90 minutes.

The thermal diffusion treatment can be performed with a known continuous furnace, a batch furnace or the like. In the thermal diffusion atmosphere, the concentration of oxygen is preferably less than 5% by volume. It is also possible to perform the thermal diffusion treatment for forming a diffusion layer by rapid thermal processing (RTP). From the viewpoint of thermal uniformity, a tunnel furnace, which is a type of a continuous furnace, is suitable.

Prior to the thermal diffusion treatment that is performed at from 600°C to 1250°C, a thermal treatment may be carried out at from 550°C to 650°C. By elevating the temperature in such a stepwise manner, organic substances that may be attached to boron nitride can be removed and diffusion of boron nitride can be facilitated.

The thermal treatment at from 550°C to 650°C is preferably performed in air, from the viewpoint of effectively removing organic substances that may be attached to boron nitride.

The thermal treatment at from 550°C to 650°C can be carried out with a ring furnace, a drying furnace, a hot plate or the like. The time for the thermal treatment is not particularly limited, and may be selected appropriately depending on the configuration of the composition for forming a p-type diffusion layer. For example, the thermal treatment may be carried out for from 1 minute to 30 minutes.

In a case in which a layer of a heat-treated product such as a glass layer is formed on the surface of the p⁺-type diffusion layer or the p⁺⁺-type diffusion layer after the thermal diffusion treatment, the glass layer or the like is removed by etching. The etching may be performed by a known method, such as a method of dipping in an acid such as hydrofluoric acid or a method of dipping in an alkali such as caustic soda, preferably a method of dipping in an aqueous solution including hydrofluoric acid.

After removing the glass layer or the like by etching, washing is carried out. The washing is preferably a combination of any one of washing with running water, scrubbing or ultrasonic washing.

Subsequently, a diffusing agent including phosphorus as a donor element is applied to a surface opposite to the surface at which a p⁺-type diffusion layer has been formed, and an n⁺-type diffusion layer is uniformly formed by performing a treatment for several ten minutes in an atmosphere of a mixed gas of nitrogen and oxygen at a temperature of from 800°C to 1000°C. By diffusing phosphorus after forming a p⁺-type diffusion layer or the like, a bulk lifetime of minority carrier can be improved.

It is also possible to form an n⁺-type diffusion layer under a phosphorus oxychloride atmosphere with a mixed gas of phosphorus oxychloride (POCl₃), nitrogen and oxygen, instead of using a diffusing agent including phosphorous. In this method, however, diffusion of phosphorus occurs not only at a front surface but also at side surfaces and a surface at which a p⁺-type diffusion layer has been formed. Therefore, in this method, it is preferred to perform side etching for removing the n-type diffusion layers formed at side surfaces, and provide a mask such as a resist on the surface at which a p⁺-type diffusion layer has been formed.

An antireflection film is formed on the n⁺-type diffusion layer. The antireflection film is formed by a known technique. For example, in a case in which the antireflection film is a silicon nitride film, the antireflection film is formed by a plasma CVD method with a mixed gas of SiH₄ and NH₃ as a raw material. During the formation of the antireflection film, hydrogen is diffused into crystals and bonded to dangling bonds, i.e., an orbit that does not contribute to bonding with silicon atoms, whereby defects are inactivated (hydrogen-passivated).

More specifically, the antireflection film is formed under the conditions of a ratio of flow of the mixed gas (NH₃/SiH₄) of from 0.05 to 1.0, a pressure in a chamber of from 13.3 Pa (0.1 Torr) to 266.6 Pa (2 Torr), a temperature during film formation of from 300°C to 550°C, and a frequency for plasma discharge of 100 kHz or more.

On the antireflection film, a metal paste layer for a front surface electrode is formed by applying a metal paste for forming a front surface electrode by a screen printing method and drying the same. The metal paste for forming a front surface electrode includes metal particles and glass particles as essential components, and optionally an organic binder and other additives.

On the regions with a high concentration of dopant such as a p⁺⁺-type diffusion layer (selected region), a metal paste layer for a back surface electrode is formed. The material for the back surface electrode is not limited to aluminum, and Ag (silver), Cu (copper) or the like can be used, for example. During this process, a silver paste layer for forming a silver electrode may be provided to a portion of the back surface of the photovoltaic cell element, for the purpose of connecting the same with another photovoltaic cell element during a module process.

A photovoltaic cell element is obtained by sintering the metal paste layers for electrodes formed on the front surface and the back surface. If the metal paste layers are sintered at from 600°C to 900°C for from several seconds to several minutes, the antireflection film that is an insulating film is molten by the glass particles included in the metal paste for an electrode at the front surface, and a surface of silicon is also partially molten, and the metal particles in the paste (for example, silver particles) form a contact portion with the silicon substrate and solidify. As a result, a front surface electrode and the silicon substrate are electrically connected with each other (fire-through).

The shape of the front surface electrode is explained. The front surface electrode is formed from, for example, bass bar electrodes and finger electrodes that are positioned across the bass bar electrodes.

The surface electrode can be formed by, for example, screen printing with the metal paste for an electrode as mentioned above, plating with a material for an electrode, or evaporation of a material for an electrode by electron beam heating under high vacuum. The front surface electrode formed from bass bar electrodes and finger electrodes is generally known, and may be formed by a known method for forming bass bar electrodes and finger electrodes on the light-receiving surface.

In the following, an embodiment of the invention will be described with reference to the drawings.

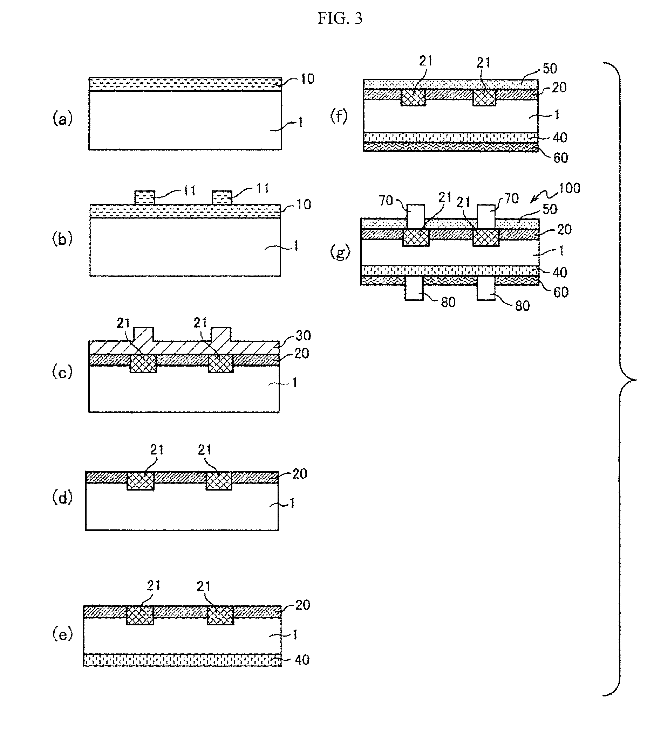

Fig. 3 illustrates a process chart for producing a p-type diffusion layer. The process chart of Fig. 3 illustrates a method of forming a p⁺-type diffusion layer and a p⁺⁺-type diffusion layer by the method (2) as described above. However, the process chart does not limit the production method of the invention.

First, a diffusing agent is applied onto a surface of n-type silicon substrate 1 and dried, whereby first diffusing agent layer 10 is formed (Fig. 3(a)). Subsequently, a diffusing agent is further applied onto portions on which electrodes are to be formed and dried, whereby second diffusing agent layer 11 is formed (Fig. 3(b)).

The diffusing agent used for forming first diffusing agent layer 10 and the diffusing agent used for forming second diffusing agent layer 10 may have different boron nitride concentrations, as described in the method (1), or may have the same concentration. Further, the diffusing agent used for forming second diffusing agent layer 11 may include highly diffusive boron nitride, as described in the method (3).

Subsequently, a thermal diffusion treatment for diffusing a dopant is performed, and p⁺⁺-type diffusion layer 21 is formed in the vicinity of a surface of the substrate at which the diffusing agent has been applied twice, and p⁺-type diffusion layer 20 is formed in the vicinity of a surface of the substrate corresponding to the portion at which the diffusing agent has been applied once (Fig. 3(c)). Further, etching is performed in order to remove heat-treated product layer 30, such as a glass layer, that has been formed on p⁺-type diffusion layer 20 and p⁺⁺-type diffusion layer 21 (Fig. 3(d)).

On a surface opposite to the surface on which p⁺-type diffusion layer 20 and p⁺⁺-type diffusion layer 21 have been formed, as shown in Fig. 3(e), n⁺-type diffusion layer 40 is formed by applying a diffusing agent for forming a n⁺-type diffusion layer and performing a thermal diffusion treatment. A heat-treated product layer (not shown in the drawing) of the diffusing agent for forming an n⁺-type diffusion layer, which is formed on n⁺-type diffusion layer 40, is removed by etching or the like.

On the surface at which p⁺-type diffusion layer 20 and p⁺⁺-type diffusion layer 21 are formed, surface protection film 50 is formed. On the surface at which n⁺-type diffusion layer 40 is formed, antireflection film 60 is formed (Fig. 3(f)).

A paste for forming a back surface electrode is applied onto p⁺⁺-type diffusion layer 21, and a paste for forming a front surface electrode is applied onto n⁺-type diffusion layer 40, and a thermal diffusion treatment is carried out. Photovoltaic cell element 100, having back surface electrode 70 on p⁺⁺-type diffusion layer 21 and front surface electrode 80 on n⁺-type diffusion layer 40, is thus obtained (Fig. 3(g)).

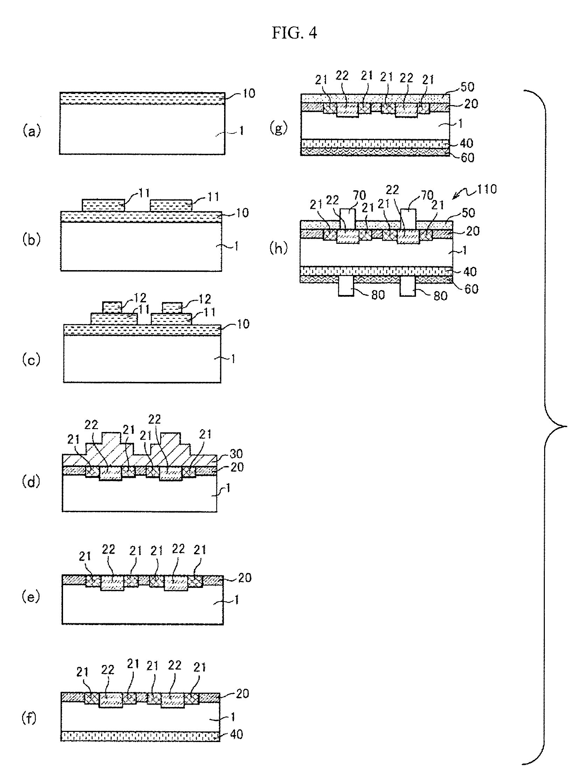

Fig. 4 illustrates another example of a process chart for forming a p-type diffusion layer. In the process chart of Fig. 4, a method of forming a p⁺-type diffusion layer, a p⁺⁺-type diffusion layer and a p⁺⁺⁺-type diffusion layer by the method (2) is explained. It should be noted that the process chart does not limit the production method of the invention.

First, on a surface of n-type silicon substrate 1, a diffusing agent is applied and dried, whereby first diffusing agent layer 10 is formed (Fig. 4(a)). Subsequently, a diffusion layer is further applied onto a portion on which an electrode is to be formed and dried, whereby second diffusing agent layer 11 is formed (Fig. 4(b)). Then, a diffusing agent is further applied onto a portion on which an electrode is to be formed and dried, whereby third diffusing agent layer 12 is formed (Fig. 4(c)).

The diffusing agent used for forming first diffusing agent layer 10, the diffusing agent used for forming second diffusing layer 11 and the diffusing agent used for forming third diffusing agent layer 12 may have different boron nitride concentrations, as described in the method (1), or may have the same concentration. Further, the diffusing agent used for forming second diffusing agent layer 11 or the diffusing agent used for forming third diffusing agent layer 12 may include highly diffusive boron nitride, as described in the method (3).

Subsequently, a dopant is diffused by performing a thermal diffusion treatment, and p⁺⁺⁺-type diffusing layer 22 is formed in the vicinity of a surface of the substrate corresponding to a portion on which the diffusing agent has been applied three times, p⁺⁺-type diffusing layer 21 is formed in the vicinity of a surface of the substrate corresponding to a portion on which the diffusing agent has been applied twice, and p⁺-type diffusing layer 20 is formed in the vicinity of a surface of the substrate corresponding to a portion on which the diffusing agent has been applied once (Fig. 4(d)). Heat-treated product layer 30 of the diffusing agent such as a glass layer, which is formed on p⁺-type diffusing layer 20, p⁺⁺-type diffusing layer 21 and p⁺⁺⁺-type diffusing layer 22, is removed by etching or the like (Fig. 4(e)).

Onto a surface opposite to the surface on which p⁺-type diffusion layer 20, p⁺⁺-type diffusion layer 21 and p⁺⁺⁺-type diffusion layer 22 have been formed, as shown in Fig. 4(f), n⁺-type diffusion layer 40 is formed by applying a diffusing agent for forming an n⁺-type diffusion layer and performing a thermal diffusion treatment. A heat-treated product layer (not shown in the drawing) of the diffusing agent for forming an n⁺-type diffusion layer, which is formed on n⁺-type diffusion layer 40, is removed by etching or the like.

On the surface at which p⁺-type diffusion layer 20, p⁺⁺-type diffusion layer 21 and p⁺⁺⁺-type diffusion layer 22 are formed, surface protection film 50 is formed. On the surface at which n⁺-type diffusion layer 40 is formed, antireflection film 60 is formed (Fig. 4(g)).

A paste for forming a back surface electrode is applied onto p⁺⁺⁺-type diffusion layer 22, and a paste for forming a front surface electrode is applied onto n⁺-type diffusion layer 40, and a thermal diffusion treatment is performed. Photovoltaic cell element 110, having electrode 70 on p⁺⁺⁺-type diffusion layer 22 and electrode 80 on n⁺-type diffusion layer 40, is thus obtained (Fig. 4(h)).

The aforementioned explanation relates to a photovoltaic cell element that has an n-type diffusion layer formed on the front surface; a p⁺-type diffusion layer, a p⁺⁺-type diffusion layer and a p⁺⁺⁺-type diffusion layer formed on the back surface; and a front surface electrode and a back surface electrode formed on the n-type diffusion layer and the n⁺⁺⁺-type diffusion layer, respectively. However, according to the production method of the invention, it is possible to produce a back contact-type photovoltaic cell element.

A back contact-type photovoltaic cell has a structure in which all electrodes are provided on the back surface in order to increase the area of the light-receiving side. Therefore, the back contact-type photovoltaic cell needs to have a pn-junction structure that is formed by providing both an n-type diffusion region and a p⁺⁺⁺-type diffusion region on the back surface. According to the method of the invention, it is possible to form a p⁺⁺⁺-type diffusion region at a specified portion. Therefore, the method of the invention is suitably applied to a method of producing a back contact-type photovoltaic cell element.

### <Photovoltaic cell>

The photovoltaic cell of the invention includes at least one photovoltaic cell element as described above and a tab line that is positioned on the electrode of the photovoltaic cell element. The photovoltaic cell may have a structure in which plural photovoltaic cell elements are connected via a tab line and encapsulated with an encapsulant.

### [Examples]

In the following, the invention is explained more specifically with reference to the examples. However, the invention is not limited to these examples. Unless otherwise specified, reagents were used as the components.

### <Example 1>

### (Preparation of boron nitride powder)

In a 45-ml zirconia container, 4 g of boron nitride having a crystal form of a hexagonal crystal (manufactured by Denki Kagaku Kogyo Kabushiki Kaisha, trade name: DENKA BORON NITRIDE GP) and 16 g of ultrapure water were placed and subjected to a pulverization treatment at 800 rpm for 30 minutes with a planetary ball mill (manufactured by Fritsch GmbH) and 30 g of yttria-stabilized zirconia beads having a diameter of 1mm and 30 g of yttria-stabilized zirconia beads having a diameter of 3mm. Subsequently, the zirconia beads were separated and a water slurry including boron nitride was dried at 150°C, thereby obtaining a boron nitride powder.

The oxygen content of the boron nitride powder was measured with an oxygen-nitrogen analyzer (TC436, manufactured by LECO Japan Corporation). The impulse furnace was set at 5400W such that the temperature inside the furnace was 1600°C. Then, 0.1 g to 0.2 g of the boron nitride powder were heated in an inert gas flow (helium) and oxygen was measured with an infrared detector. The obtained spectrum was compared with a standard substance whose oxygen content was known (yttrium oxide), and the oxygen content was calculated. The oxygen content was 1.2% by mass.

### (Preparation of composition for forming p-type diffusion layer)

A solution was prepared by dissolving ethyl cellulose as an organic binder (manufactured by Nissin & Co., Ltd., trade name: ETHOCEL) in a terpineol solution as a dispersion medium (manufactured by Nippon Terpene Chemicals, Inc.) 8 g of the solution and 2 g of the pulverized boron nitride powder were mixed in a mortar, and 1 g of a silicone resin as an inorganic binder (manufactured by Shin-Etsu Chemical Co., Ltd., trade name: X-40-9250) was added, whereby a composition for forming a p-type diffusion layer (hereinafter, also simply referred to as a "paste") was prepared.

### (Thermal diffusion process)

On a surface of a sliced n-type silicon substrate, the obtained paste was applied by screen printing and dried on a hot plate at 150°C for 5 minutes. Subsequently, the n-type silicon substrate was subjected to a thermal treatment in a ring furnace under an air flow of 5L/min at 600°C for 1 minute. After cooling, the n-type silicon substrate was taken out from the ring furnace. A heat-treated product of the composition for forming a p-type diffusion layer was formed on a region onto which the paste had been applied.

(Evaluation of binding property)

An air gun was placed at a position apart from the n-type silicon substrate, and a compressed air of 19.6 X 10⁻⁴ Pa (2 kgf/cm²) was blown thereto. The amount of scattering of a heat-treated product of the composition for forming a p-type diffusion layer was measured and evaluated in accordance with the following evaluation criteria. The results are shown in Table 1.

### <Evaluation criteria>

A: Favorable (a change in mass of the composition for forming a p-type diffusion layer is less than 0.1 % by mass)
B: Tolerable (a change in mass of the composition for forming a p-type diffusion layer is from 0.1 % by mass to 2% by mass)
C: Poor (a change in mass of the composition for forming a p-type diffusion layer is greater than 2% by mass)
C is a grade that is problematic from a practical perspective.

As shown in Table 1, the change in mass before and after the blowing was less than 0.1% by mass, i.e., scattering of the heat-treated product of the composition for forming a p-type diffusion layer was not observed.

### (Etching process)

Subsequently, the n-type silicon substrate as described above was washed with running water, and the n-type silicon substrate was dipped in a HF aqueous solution (2.5% by mass) for 5 minutes. Then, the n-type silicon substrate was subjected to washing with running water, ultrasonic washing and drying, in order to remove the heat-treated product formed on the n-type silicon substrate. An n-type silicon substrate having a p-type diffusion layer was thus obtained.

### (Measurement of sheet resistance)

The sheet resistance of the n-type silicon substrate having a p-type diffusion layer was measured by a four-pin probe method with a low resistivity meter (manufactured by Mitsubishi Chemical Corporation, trade name: LORESTA-EP MCP-T360).

As a result, the sheet resistivity at a portion onto which the composition for forming a p-type diffusion layer had been applied was 300 Ω/sq., and a p-type diffusion layer was formed by diffusion of B (boron).

### (Measurement of XRD pattern of substrate)

The XRD pattern of the n-type silicon substrate having a p-type diffusion layer was measured. As a result, no peaks other than that derived from the silicon substrate were observed.

The n-type silicon substrate having a p-type diffusion layer had no warpage.

### <Example 2>

A composition for forming a p-type diffusion layer was prepared in a similar manner to Example 1, except that tetraethoxysilane (manufactured by Wako Pure Chemical Industries, Ltd., special grade) was used instead of the silicon resin, and an n-type silicon substrate having a p-type diffusion layer was prepared in a similar manner to the above. Then, evaluation of the binding property and measurement of the sheet resistance were performed. The results are shown in Table 1.

### <Example 3>

A composition for forming a p-type diffusion layer was prepared in a similar manner to Example 2, except that the amount of tetraethoxysilane was changed from 1 g to 0.5 g, and an n-type silicon substrate having a p-type diffusion layer was prepared in a similar manner to the above. Then, evaluation of the binding property and measurement of the sheet resistance were performed. The results are shown in Table 1.

### <Example 4>

A composition for forming a p-type diffusion layer was prepared in a similar manner to Example 1, except that a silane coupling agent (manufactured by Shin-Etsu Chemical Co., Ltd., trade name: KP-323) was used instead of the silicon resin, and an n-type silicon substrate having a p-type diffusion layer was prepared in a similar manner to the above. Then, evaluation of the binding property and measurement of the sheet resistance were performed. The results are shown in Table 1.

### <Example 5>

### (Preparation of glass frit 1)

SiO₂, B₂O₃ and ZnO (manufactured by Kojundo Chemical Lab. Co., Ltd., respectively) as raw materials were mixed such that the molar ratio thereof (SiO₂:B₂O₃:ZnO) was 10:40:50, and the mixture was placed in an alumina melting pot. The temperature was increased to 1350°C at a rate of 400°C /h, retained for one hour, and rapidly cooled. The mixture is then pulverized with an automatic mortar kneading apparatus, thereby obtaining glass frit 1.

The X-ray diffraction (XRD) pattern of glass frit 1 was measured with an X-ray diffraction analyzer (manufactured by Rigaku Corporation, trade name: RINT-2000) using a Cu-Kα line and a Ni filter. As a result, it was confirmed that glass frit 1 is amorphous.

The volume average secondary particle diameter of glass frit 1 was measured in the form of an aqueous dispersion with a laser diffraction and scattering method particle diameter distribution analyzer (manufactured by Beckman Coulter, Inc., product name: LS 13 320). As a result, the volume average secondary particle diameter was 6 µm.

A composition for forming a p-type diffusion layer was prepared in a similar manner to Example 1, except that glass frit 1 was used instead of the silicon resin, and an n-type silicon substrate having a p-type diffusion layer was prepared in a similar manner to the above. Then, evaluation of the binding property and measurement of the sheet resistance were performed. The results are shown in Table 1.

### <Example 6>

### (Preparation of glass frit 2)

SiO₂, CaO and ZnO (manufactured by Kojundo Chemical Lab. Co., Ltd., respectively) as the raw materials were mixed such that the molar ratio thereof (SiO₂:CaO:ZnO) was 50:20:30, and the mixture was placed in an alumina melting pot. The temperature was increased to 1500°C at a rate of 400°C /h, retained for one hour, and slowly cooled in the melting pot. The mixture is then pulverized with an automatic mortar kneading apparatus, thereby obtaining glass frit 2.

The powder X-ray diffraction (XRD) pattern of glass frit 2 was measured in a similar manner to Example 5. As a result, it was confirmed that glass frit 2 is amorphous.

The volume average secondary particle diameter of glass frit 2 was measured in a similar manner to Example 5. As a result, the volume average secondary particle diameter was 7 µm.

A similar procedure to Example 1 was performed, except that glass frit 2 was used instead of the silicone resin. The results are shown in Table 1.

### <Example 7>

A similar procedure to Example 1 was carried out, except that a B₂O₃-SiO₂-RO glass frit (R represents any one of Mg, Ca, Sr or Ba) (manufactured by Tokan Material Technorogy Co., Ltd., trade name: TMX-603C) was used instead of the silicone resin. The results are shown in Table 1.

### <Example 8>

A similar procedure to Example 2 was carried out, except that the amount of tetraethoxysilane was changed from 1 g to 0.1 g. The results are shown in Table 1.

### <Comparative Example 1>

A similar procedure to Example 1 was carried out, except that silicone resin as an inorganic binder was not added. The results are shown in Table 1.

### <Comparative Example 2>

A composition for forming a p-type diffusion layer was prepared in a similar manner to Example 1, except that boron oxide (B₂O₃, manufactured by Kojundo Chemical Lab. Co., Ltd.) was used instead of the boron nitride. The composition was applied onto an n-type silicon substrate and a thermal treatment was performed in a similar manner to Example 1.

A black precipitate remained at a portion onto which the composition for forming a p-type diffusion layer including boron oxide had been applied, even after performing etching and washing with water. The resistivity was 1000 Ω/sq.

According to the measurement of the XRD pattern of the n-type silicon substrate, a peak of crystallization that is not derived from the silicon substrate was observed, and a reactant of boron oxide with the silicon substrate was observed even after performing etching.

**Table 1**

| | Sheet Resistivity (Ω/sq.) | Binding Property |
|---|---|---|
| Example 1 | 300 | A |
| Example 2 | 90 | A |
| Example 3 | 88 | A |
| Example 4 | 320 | A |
| Example 5 | 50 | A |
| Example 6 | 300 | A |
| Example 7 | 65 | A |
| Example 8 | 75 | B |
| Comparative Example 1 | 70 | C |

As shown above, it is seen that scattering of boron nitride on a silicon substrate after a thermal diffusion process can be suppressed by using a composition for forming a p-type diffusion layer that includes an inorganic binder.

Further, the XRD pattern of the n-type silicon substrate having a p-type diffusion layer of Examples 2 to 8 did not show a peak other than that derived from the silicon substrate. In addition, the n-type silicon substrate having a p-type diffusion layer of Examples 2 to 8 had no warpage.

### (Preparation of boron nitride particles with oxygen content of 15% by mass or less)

### <Preparation Example 1>

The oxygen content of boron nitride particles having a crystal form of a hexagonal crystal (manufactured by Wako Pure Chemical Industries, Ltd., special grade, volume average secondary particle diameter: 11.7 µm, volume average primary particle diameter: 11 µm).

The oxygen content of the boron nitride powder was measured with an oxygen-nitrogen analyzer (TC436, manufactured by LECO Japan Corporation). The impulse furnace was set at 5400W such that the temperature inside the furnace was 1600°C. Then, 0.1 g to 0.2 g of the boron nitride powder were heated in an inert gas flow (helium) and oxygen was measured with an infrared detector. The obtained spectrum was compared with a standard substance whose oxygen content was known (yttrium oxide), and the oxygen content was calculated. The oxygen content was 0.52% by mass.

### <Preparation Example 2>

A bead mill (manufactured by AIMEX Co.,Ltd., NVM-2) was used as a wet milling machine. Boron nitride (manufactured by Denki Kagaku Kogyo Kabushiki Kaisha, trade name: DENKA BORON NITRIDE [GP]) was subjected to wet milling in an aqueous medium for 30 minutes with yttria-stabilized zirconia beads having a diameter of 0.5 mm. The obtained water dispersion slurry was dried to solidify at 140°C, thereby obtaining boron nitride particles.

The X-ray diffraction spectrum and the oxygen content of the boron nitride particles were measured in a similar manner to Preparation Example 1. From the X-ray diffraction spectrum, a diffraction pattern attributed to boron nitride having a hexagonal crystal was observed. The oxygen content was 1.22% by mass.

### <Preparation Example 3>

Boron nitride particles were prepared in a similar manner to Preparation Example 2, except that the time for pulverization with a bead mill was changed from 30 minutes to 60 minutes.

The X-ray diffraction spectrum and the oxygen content of the boron nitride particles were measured in a similar manner to Preparation Example 1. From the X-ray diffraction spectrum, a diffraction pattern attributed to boron nitride having a hexagonal crystal was observed. The oxygen content was 1.28% by mass.

### <Preparation Example 4>

Boron nitride particles were prepared in a similar manner to Preparation Example 2, except that the time for pulverization with a bead mill was changed from 30 minutes to 90 minutes.

The X-ray diffraction spectrum and the oxygen content of the boron nitride particles were measured in a similar manner to Preparation Example 1. From the X-ray diffraction spectrum, a diffraction pattern attributed to boron nitride having a hexagonal crystal was observed. The oxygen content was 1.81% by mass.

### <Preparation Example 5>

Boron nitride particles were prepared in a similar manner to Preparation Example 2, except that the time for pulverization with a bead mill was changed from 30 minutes to 120 minutes.

The X-ray diffraction spectrum and the oxygen content of the boron nitride particles were measured in a similar manner to Preparation Example 1. From the X-ray diffraction spectrum, a diffraction pattern attributed to boron nitride having a hexagonal crystal was observed. The oxygen content was 1.78% by mass.

### <Preparation Example 6>

Boron nitride particles were prepared by sintering boron nitride (manufactured by Denki Kagaku Kogyo Kabushiki Kaisha, trade name: DENKA BORON NITRIDE [GP]) in an air atmosphere at 950°C for 10 minutes.

The X-ray diffraction spectrum and the oxygen content of the boron nitride particles were measured in a similar manner to Preparation Example 1. From the X-ray diffraction spectrum, a diffraction pattern attributed to boron nitride having a hexagonal crystal was observed. The oxygen content was 2.06% by mass.

### <Preparation Example 7>

Boron nitride particles were prepared by sintering boron nitride (manufactured by Denki Kagaku Kogyo Kabushiki Kaisha, trade name: DENKA BORON NITRIDE [GP]) in an air atmosphere at 950°C for 60 minutes.

The X-ray diffraction spectrum and the oxygen content of the boron nitride particles were measured in a similar manner to Preparation Example 1. From the X-ray diffraction spectrum, a diffraction pattern attributed to boron nitride having a hexagonal crystal was observed. The oxygen content was 3.45% by mass.

### <Preparation Example 8>

Boron nitride particles were prepared by sintering boron nitride (manufactured by Denki Kagaku Kogyo Kabushiki Kaisha, trade name: DENKA BORON NITRIDE [GP]) in an air atmosphere at 1000°C for 30 minutes.

The X-ray diffraction spectrum and the oxygen content of the boron nitride particles were measured in a similar manner to Preparation Example 1. From the X-ray diffraction spectrum, a diffraction pattern attributed to boron nitride having a hexagonal crystal was observed. The oxygen content was 4.28% by mass.

### <Preparation Example 9>

In a 45-cc zirconia container, 1 g of boron nitride and 4 g of ultrapure water were placed and subjected to a pulverization treatment at 600 rpm for 30 minutes with a planetary ball mill (manufactured by Fritsch GmbH), 30 g of yttria-stabilized zirconia beads having a diameter of 1mm and 30 g of yttria-stabilized zirconia beads having a diameter of 3 mm.

The volume average secondary particle diameter of the pulverized boron nitride was 6.3 µm, and the volume average primary particle diameter was 2 µm. The oxygen content was 1.60% by mass.

### <Preparation Example 10>

In a 45-cc zirconia container, 4 g of boron nitride and 16 g of ultrapure water were placed and subjected to a pulverization treatment at 600 rpm for 30 minutes with a planetary ball mill (manufactured by Fritsch GmbH), 30 g of yttria-stabilized zirconia beads having a diameter of 1mm and 30 g of yttria-stabilized zirconia beads having a diameter of 3 mm.

The volume average secondary particle diameter of the pulverized boron nitride was 9.4 µm, and the volume average primary particle diameter was 4 µm. The oxygen content was 1.30% by mass.

A composition for forming a p-type diffusion layer was prepared by using boron nitride particles obtained in Preparation Examples 1 to 10, respectively, and an n-type silicon substrate having a p-type diffusion layer was prepared. The n-type silicon substrate had no warpage. The sheet resistivity was low and favorable results were obtained.

### [Explanation of Symbols]

### 1 Silicon substrate

2 and 5 Heat-treated product layer
3 p⁺-type diffusion layer
4 and 8 Electrode
6 n⁺-type diffusion layer
7 Antireflection film or surface protection film
10 First diffusing agent layer
11 Second diffusing agent layer
12 Third diffusing agent layer
20 p⁺-type diffusion layer
21 p⁺⁺-type diffusion layer
22 p⁺⁺⁺-type diffusion layer
30 Heat-treated product layer
40 n⁺-type diffusion layer
50 Surface protection film
60 Antireflection film
70 and 80 Electrode
100 and 110 Photovoltaic cell element

## Claims

1. A composition for forming a p-type diffusion layer, the composition comprising boron nitride, a dispersion medium and an inorganic binder, **characterized in that** the boron nitride has a BET specific surface area of 3 m²/g to 200 m²/g.

2. The composition for forming a p-type diffusion layer according to claim 1,
wherein the inorganic binder is at least one selected from the group consisting of an organic metal compound and a glass frit.

3. The composition for forming a p-type diffusion layer according to claim 2,
wherein the organic metal compound is at least one selected from the group consisting of a metal alkoxide, a silane coupling agent and a silicone resin.

4. The composition for forming a p-type diffusion layer according to claim 3,
wherein the metal alkoxide is silicon alkoxide.

5. The composition for forming a p-type diffusion layer according to claim 2,
wherein the glass frit comprises borosilicate glass.

6. The composition for forming a p-type diffusion layer according to any one of claims 1 to 5, wherein a content of the inorganic binder is from 1% by mass to 40% by mass.

7. The composition for forming a p-type diffusion layer according to any one of claims 1 to 6, wherein the dispersion medium comprises an organic binder.

8. The composition for forming a p-type diffusion layer according to any one of claims 1 to 7, wherein the boron nitride is boron nitride particles having a crystalline form of a hexagonal crystal.

9. The composition for forming a p-type diffusion layer according to any one of claims 1 to 8, wherein the boron nitride has a peak intensity ratio of peaks each corresponding to (100), (101) and (102) in an X-ray diffraction pattern, represented by [(I₁₀₀)+I(₁₀₁)/I(₁₀₂)], of 3.5 or less.

10. The composition for forming a p-type diffusion layer according to any one of claims 1 to 9, wherein the boron nitride is boron nitride particles having a content of oxygen atoms of 15% by mass or less.

11. The composition for forming a p-type diffusion layer according to claim 10, wherein the boron nitride particles are at least one selected from the group consisting of a product that has been subjected to mechanical surface modification and a product that has been subjected to a thermal treatment.

12. A method of producing a silicon substrate having a p-type diffusion layer, the method comprising a process of applying, to a silicon substrate, the composition for forming a p-type diffusion layer according to any one of claims 1 to 11 and, after the process of applying, a process of performing a thermal diffusion treatment by heating the silicon substrate.

13. A method of producing a photovoltaic cell element (100, 110), the method comprising a process of applying, to a silicon substrate (1), the composition for forming a p-type diffusion layer according to any one of claims 1 to 11 and, after the process of applying, a process of forming a p-type diffusion layer (20, 21, 22) by performing a thermal diffusion treatment by heating the silicon substrate (1), and a process of forming an electrode (70, 80) on the p-type diffusion layer (20, 21, 22).

14. A method of producing a silicon substrate having a p-type diffusion layer that has a selective emitter structure, the method comprising a process of applying, to a silicon substrate, the composition for forming a p-type diffusion layer according to any one of claims 1 to 11 by a method that is at least one selected from the following (1) to (3) and, after the process of applying, a process of performing a thermal diffusion treatment by heating the silicon substrate:
(1) using at least two compositions for forming a p-type diffusion layer having different concentrations of boron nitride as the composition for forming a p-type diffusion layer, and applying, to the selected region, a composition for forming a p-type diffusion layer having a higher concentration of boron nitride;
(2) applying, to the selected region, a composition for forming a p-type diffusion layer more than once; and
(3) applying, to the selected region, a composition for forming a p-type diffusion layer that includes highly diffusive boron nitride.

15. The method of producing a silicon substrate having a p-type diffusion layer according to claim 14, wherein the application of the composition for forming a p-type diffusion layer to the selected region is an inkjet method, an offset printing method or a screen printing method.

16. The method of producing a silicon substrate having a p-type diffusion layer according to claim 14 or 15, wherein the process of application comprises:
a first application process in which the composition for forming a p-type diffusion layer is partially applied to the selected region and dried; and
a second application process in which the composition for forming a p-type diffusion layer is applied to an entire region of the surface to which the application is carried out in the first application process, and dried.

17. The method of producing a silicon substrate having a p-type diffusion layer according to claim 14 or 15, wherein the process of application comprises:
a first application process in which the composition for forming a p-type diffusion layer is applied to an entire region including the selected region and dried; and
a second application process in which the composition for forming a p-type diffusion layer is partially applied to the selected region, and dried.

18. A method of producing a photovoltaic cell element (100, 110), the method comprising a process of forming an electrode (70, 80) on the selected region of the silicon substrate (1) having a p-type diffusion layer (20, 21, 22) that has been produced by the method according to any one of claims 14 to 17.

19. A photovoltaic cell comprising the photovoltaic cell element (100, 110) that is produced by the method according to claim 13 or 18, and a tab line that is positioned on the electrode (70, 80) of the photovoltaic cell element (100, 110).

## Patentansprüche

1. Zusammensetzung zur Bildung einer p-Diffusionsschicht, wobei die Zusammensetzung Bornitrid, ein Dispersionsmedium und ein anorganisches Bindemittel umfasst, **dadurch gekennzeichnet, dass** das Bornitrid eine spezifische BET-Oberfläche von 3 m²/g bis 200 m²/g aufweist.

2. Zusammensetzung zur Bildung einer p-Diffusionsschicht gemäß Anspruch 1, worin das anorganische Bindemittel mindestens eines, ausgewählt aus der Gruppe bestehend aus einer organischen Metallverbindung und Glasfritte, ist.

3. Zusammensetzung zur Bildung einer p-Diffusionsschicht gemäß Anspruch 2, worin die organische Metallverbindung mindestens eine, ausgewählt aus der Gruppe bestehend aus einem Metallalkoxid, einem Silanhaftvermittler und einem Silikonharz, ist.

4. Zusammensetzung zur Bildung einer p-Diffusionsschicht gemäß Anspruch 3, worin das Metallalkoxid Siliziumalkoxid ist.

5. Zusammensetzung zur Bildung einer p-Diffusionsschicht gemäß Anspruch 2, wobei die Glasfritte Borsilikatglas umfasst.

6. Zusammensetzung zur Bildung einer p-Diffusionsschicht gemäß irgendeinem der Ansprüche 1 bis 5, worin ein Gehalt an dem anorganischen Bindemittel 1 Masse% bis 40 Masse% beträgt.

7. Zusammensetzung zur Bildung einer p-Diffusionsschicht gemäß irgendeinem der Ansprüche 1 bis 6, worin das Dispersionsmedium ein organisches Bindemittel umfasst.

8. Zusammensetzung zur Bildung einer p-Diffusionsschicht gemäß irgendeinem der Ansprüche 1 bis 7, worin das Bornitrid Bornitridpartikel mit einer kristallinen Form eines hexagonalen Kristalls ist.

9. Zusammensetzung zur Bildung einer p-Diffusionsschicht gemäß irgendeinem der Ansprüche 1 bis 8, worin das Bornitrid ein Peakintensitätsverhältnis von Peaks, die jeweils (100), (101) bzw. (102) in einem Röntgenbeugungsmuster entsprechen, dargestellt durch [(I₁₀₀)+I(₁₀₁)/I(₁₀₂)], von 3,5 oder weniger aufweist.

10. Zusammensetzung zur Bildung einer p-Diffusionsschicht gemäß irgendeinem der Ansprüche 1 bis 9, worin das Bornitrid Bornitridpartikel mit einem Gehalt an Sauerstoffatomen von 15 Masse% oder weniger ist.

11. Zusammensetzung zur Bildung einer p-Diffusionsschicht gemäß Anspruch 10, worin die Bornitridpartikel mindestens eines, ausgewählt aus der Gruppe bestehend aus einem Produkt, das einer mechanischen Oberflächenmodifikation unterzogen wurde, und einem Produkt, das einer thermischen Behandlung unterzogen wurde, sind.

12. Verfahren zur Herstellung eines Siliziumsubstrats mit einer p-Diffusionsschicht, wobei das Verfahren einen Vorgang zur Auftragung der Zusammensetzung zur Bildung einer p-Diffusionsschicht gemäß irgendeinem der Ansprüche 1 bis 11 auf einem Siliziumsubstrat, und nach dem Auftragungsvorgang einen Vorgang zur Durchführung einer thermischen Diffusionsbehandlung durch Erwärmen des Siliziumsubstrats umfasst.

13. Verfahren zur Herstellung eines photovoltaischen Zellelements (100, 110), wobei das Verfahren einen Vorgang zur Auftragung der Zusammensetzung zur Bildung einer p-Diffusionsschicht gemäß irgendeinem der Ansprüche 1 bis 11 auf ein Siliziumsubstrat (1) und nach dem Auftragungsvorgang einen Vorgang zur Bildung einer p-Diffusionsschicht (20, 21, 22) mittels Durchführen einer thermischen Diffusionsbehandlung durch Erhitzen des Siliziumsubstrats (1) und einen Vorgang zur Bildung einer Elektrode (70, 80) auf der p-Diffusionsschicht (20, 21, 22) umfasst.

14. Verfahren zur Herstellung eines Siliziumsubstrats mit einer p-Diffusionsschicht, das eine selektive Emitterstruktur aufweist, wobei das Verfahren einen Vorgang zur Auftragung der Zusammensetzung zur Bildung einer p-Diffusionsschicht gemäß irgendeinem der Ansprüche 1 bis 11 auf ein Siliziumsubstrat durch ein Verfahren, das mindestens eines, ausgewählt aus den folgenden (1) bis (3), ist, und nach dem Auftragungsvorgang einen Vorgang zur Durchführung einer thermischen Diffusionsbehandlung durch Erwärmen des Siliziumsubstrats umfasst:
(1) Verwenden von mindestens zwei Zusammensetzungen zur Bildung einer p-Diffusionsschicht mit verschiedenen Konzentrationen an Bornitrid als Zusammensetzung zur Bildung einer p-Diffusionsschicht und Auftragen einer Zusammensetzung zur Bildung einer p-Diffusionsschicht mit einer höheren Konzentration an Bornitrid auf den ausgewählten Bereich;
(2) mehrmaliges Auftragen einer Zusammensetzung zur Bildung einer p-Diffusionsschicht auf den ausgewählten Bereich; und
(3) Auftragen einer Zusammensetzung zur Bildung einer p-Diffusionsschicht, die ein stark diffusives Bornitrid einschließt, auf den ausgewählten Bereich.

15. Verfahren zur Herstellung eines Siliziumsubstrats mit einer p-Diffusionsschicht gemäß Anspruch 14, wobei die Auftragung der Zusammensetzung zur Bildung einer p-Diffusionsschicht auf den ausgewählten Bereich ein Tintenstrahlverfahren, ein Offsetdruckverfahren oder ein Siebdruckverfahren ist.

16. Verfahren zur Herstellung eines Siliziumsubstrats mit einer p-Diffusionsschicht gemäß Anspruch 14 oder 15, wobei der Vorgang zur Auftragung Folgendes umfasst:
einen ersten Auftragungsvorgang, in dem die Zusammensetzung zur Bildung einer p-Diffusionsschicht teilweise auf den ausgewählten Bereich aufgetragen und getrocknet wird, und
einen zweiten Auftragungsvorgang, in dem die Zusammensetzung zur Bildung einer p-Diffusionsschicht auf einen gesamten Bereich der Oberfläche, auf die die Auftragung im ersten Auftragungsvorgang durchgeführt wurde, aufgetragen und getrocknet wird.

17. Verfahren zur Herstellung eines Siliziumsubstrats mit einer p-Diffusionsschicht gemäß Anspruch 14 oder 15, wobei der Vorgang zur Auftragung Folgendes umfasst:
einen ersten Auftragungsvorgang, in dem die Zusammensetzung zur Bildung einer p-Diffusionsschicht auf einen gesamten Bereich, der den ausgewählten Bereich einschließt, aufgetragen und getrocknet wird, und
einen zweiten Auftragungsvorgang, in dem die Zusammensetzung zur Bildung einer p-Diffusionsschicht teilweise auf den ausgewählten Bereich aufgetragen und getrocknet wird.

18. Verfahren zur Herstellung eines photovoltaischen Zellelements (100, 110), wobei das Verfahren einen Vorgang zur Bildung einer Elektrode (70, 80) auf den ausgewählten Bereich des Siliziumsubstrats (1) mit einer p-Diffusionsschicht (20, 21, 22), die durch das Verfahren gemäß irgendeinem der Ansprüche 14 bis 17 hergestellt wurde, umfasst.

19. Photovoltaische Zelle, umfassend das photovoltaische Zellelement (100, 110), das das durch das Verfahren gemäß Anspruch 13 oder 18 hergestellt wurde, und eine tab-Leitung, die an der Elektrode (70, 80) des photovoltaischen Zellelements (100, 110) positioniert ist.

## Revendications

1. Composition de formation d'une couche de diffusion de type p, la composition comprenant du nitrure de bore, un milieu de dispersion et un liant inorganique, **caractérisée en ce que** le nitrure de bore a une surface spécifique BET de 3 m²/g à 200 m²/g.

2. Composition de formation d'une couche de diffusion de type p selon la revendication 1, dans laquelle le liant inorganique est au moins un sélectionné parmi le groupe constitué d'un composé métallique organique et d'une fritte de verre.

3. Composition de formation d'une couche de diffusion de type p selon la revendication 2, dans laquelle le composé métallique organique est au moins un sélectionné parmi le groupe constitué d'un alcoxyde de métal, d'un agent de couplage silane et d'une résine de silicone.

4. Composition de formation d'une couche de diffusion de type p selon la revendication 3, dans laquelle l'alcoxyde de métal est l'alcoxyde de silicium.

5. Composition de formation d'une couche de diffusion de type p selon la revendication 2, dans laquelle la fritte de verre comprend du verre borosilicate.

6. Composition de formation d'une couche de diffusion de type p selon l'une quelconque des revendications 1 à 5, dans laquelle une teneur en liant inorganique est de 1 % en masse à 40 % en masse.

7. Composition de formation d'une couche de diffusion de type p selon l'une quelconque des revendications 1 à 6, dans laquelle le milieu de dispersion comprend un liant organique.

8. Composition de formation d'une couche de diffusion de type p selon l'une quelconque des revendications 1 à 7, dans laquelle le nitrure de bore est des particules de nitrure de bore ayant une forme cristalline d'un cristal hexagonal.

9. Composition de formation d'une couche de diffusion de type p selon l'une quelconque des revendications 1 à 8, dans laquelle le nitrure de bore a un rapport d'intensité de pic de pics correspondant chacun à (100), (101) et (102) dans un diagramme de diffraction des rayons X, représenté par [(I₁₀₀)+I(₁₀₁)/I(₁₀₂)], de 3,5 ou moins.

10. Composition de formation d'une couche de diffusion de type p selon l'une quelconque des revendications 1 à 9, dans laquelle le nitrure de bore est des particules de nitrure de bore ayant une teneur en atomes d'oxygène de 15 % en masse ou moins.

11. Composition de formation d'une couche de diffusion de type p selon la revendication 10, dans laquelle les particules de nitrure de bore sont au moins un sélectionné parmi le groupe constitué d'un produit qui a été soumis à une modification mécanique de surface et d'un produit qui a été soumis à un traitement thermique.

12. Procédé de production d'un substrat de silicium ayant une couche de diffusion de type p, le procédé comprenant un processus d'application, à un substrat de silicium, de la composition de formation d'une couche de diffusion de type p selon l'une quelconque des revendications 1 à 11 et, après le processus d'application, un processus de réalisation d'un traitement de diffusion thermique par chauffage du substrat de silicium.

13. Procédé de production d'un élément de cellule photovoltaïque (100, 110), le procédé comprenant un processus d'application, à un substrat de silicium (1), de la composition de formation d'une couche de diffusion de type p selon l'une quelconque des revendications 1 à 11 et, après le processus d'application, un processus de formation d'une couche de diffusion de type p (20, 21, 22) par réalisation d'un traitement de diffusion thermique par chauffage du substrat de silicium (1), et un processus de formation d'une électrode (70, 80) sur la couche de diffusion de type p (20, 21, 22).

14. Procédé de production d'un substrat de silicium ayant une couche de diffusion de type p qui a une structure émettrice sélective, le procédé comprenant un processus d'application, à un substrat de silicium, de la composition de formation d'une couche de diffusion de type p selon l'une quelconque des revendications 1 à 11 par un procédé qui est au moins l'un sélectionné parmi les points (1) à (3) suivants et, après le processus d'application, un processus de réalisation d'un traitement de diffusion thermique par chauffage du substrat de silicium :
(1) utilisation d'au moins deux compositions de formation d'une couche de diffusion de type p ayant différentes concentrations en nitrure de bore en tant que la composition de formation d'une couche de diffusion de type p, et application, à la région sélectionnée, d'une composition de formation d'une couche de diffusion de type p ayant une concentration supérieure en nitrure de bore ;
(2) application, à la région sélectionnée, d'une composition de formation d'une couche de diffusion de type p plus d'une fois ; et
(3) application, à la région sélectionnée, d'une composition de formation d'une couche de diffusion de type p qui comprend du nitrure de bore fortement diffusif.

15. Procédé de production d'un substrat de silicium ayant une couche de diffusion de type p selon la revendication 14, dans lequel l'application de la composition de formation d'une couche de diffusion de type p à la région sélectionnée est un procédé à jet d'encre, un procédé d'impression offset ou un procédé de sérigraphie.

16. Procédé de production d'un substrat de silicium ayant une couche de diffusion de type p selon la revendication 14 ou 15, dans lequel le processus d'application comprend :
un premier processus d'application dans lequel la composition de formation d'une couche de diffusion de type p est partiellement appliquée à la région sélectionnée et séchée ; et
un second processus d'application dans lequel la composition de formation d'une couche de diffusion de type p est appliquée à la totalité d'une région de la surface sur laquelle l'application est réalisée dans le premier processus d'application, et séchée.

17. Procédé de production d'un substrat de silicium ayant une couche de diffusion de type p selon la revendication 14 ou 15, dans lequel le processus d'application comprend :
un premier processus d'application dans lequel la composition de formation d'une couche de diffusion de type p est appliquée à la totalité d'une région comprenant la région sélectionnée et séchée ; et
un second processus d'application dans lequel la composition de formation d'une couche de diffusion de type p est partiellement appliquée à la région sélectionnée, et séchée.

18. Procédé de production d'un élément de cellule photovoltaïque (100, 110), le procédé comprenant un processus de formation d'une électrode (70, 80) sur la région sélectionnée du substrat de silicium (1) ayant une couche de diffusion de type p (20, 21, 22) qui a été produite par le procédé selon l'une quelconque des revendications 14 à 17.

19. Cellule photovoltaïque comprenant l'élément de cellule photovoltaïque (100, 110) qui est produit par le procédé selon la revendication 13 ou 18, et une ligne de languette qui est positionnée sur l'électrode (70, 80) de l'élément de cellule photovoltaïque (100, 110).
